# EUROPÄISCHE PATENTSCHRIFT

(11) **EP 3 592 697 B1**
(45) Veröffentlichungstag und Bekanntmachung des Hinweises auf die Patenterteilung: **14.09.2022**
(21) Anmeldenummer: 18712811.1
(22) Anmeldetag: 08.03.2018
(51) Int. Cl.: B82Y 40/00, H01M 4/04, B81C 1/00, C25D 1/00, C25D 1/04, H01L 23/00

(54) **VORRICHTUNG UND VERFAHREN ZUM BEREITSTELLEN EINER VIELZAHL VON NANODRÄHTEN**
ARRANGEMENT AND METHOD FOR PROVIDING A PLURALITY OF NANOWIRES
DISPOSITIF ET PROCÉDÉ DE MISE À DISPOSITION D'UNE PLURALITÉ DE NANOFILS

(30) Priorität: 08.03.2017 DE 102017104905; 08.03.2017 DE 102017104902
(43) Veröffentlichungstag der Anmeldung: 15.01.2020
(73) Patentinhaber: NanoWired GmbH, 64579 Gernsheim (DE)
(72) Erfinder: BIRLEM, Olav, 68642 Bürstadt (DE); QUEDNAU, Sebastian, 64283 Darmstadt (DE); ROUSTAIE, Farough, 64283 Darmstadt (DE); DASSINGER, Florian, 64283 Darmstadt (DE); SCHLAAK, Helmut F., 64283 Darmstadt (DE)
(74) Vertreter: Keenway Patentanwälte Neumann Heine Taruttis
(86) Internationale Anmeldenummer: PCT/EP2018/055836
(87) Internationale Veröffentlichungsnummer: WO 2018/162682

(56) Entgegenhaltungen:
- CN-A- 1 349 240
- DE-A1-102010 053 782
- US-A1- 2012 298 502
- ROUSTAIE FAROUGH ET AL: "In situ synthesis of metallic nanowire arrays for ionization gauge electron sources", JOURNAL OF VACUUM SCIENCE & TECHNOLOGY B: MICROELECTRONICS AND NANOMETER STRUCTURES, AMERICAN INSTITUTE OF PHYSICS, 2 HUNTINGTON QUADRANGLE, MELVILLE, NY 11747, Bd. 34, Nr. 2, 12. Januar 2016 (2016-01-12), XP012203870, ISSN: 2166-2746, DOI: 10.1116/1.4939756 [gefunden am 1901-01-01]
- ARIANNA GAMBIRASI ET AL: "Direct electrodeposition of metal nanowires on electrode surface", ELECTROCHIMICA ACTA, ELSEVIER SCIENCE PUBLISHERS, BARKING, GB, Bd. 56, Nr. 24, 13. Juli 2011 (2011-07-13) , Seiten 8582-8588, XP028289239, ISSN: 0013-4686, DOI: 10.1016/J.ELECTACTA.2011.07.045 [gefunden am 2011-07-23]
- XING DAI ET AL: "Flexible Light-Emitting Diodes Based on Vertical Nitride Nanowires", NANO LETTERS, Bd. 15, Nr. 10, 9. September 2015 (2015-09-09), Seiten 6958-6964, XP055437780, ISSN: 1530-6984, DOI: 10.1021/acs.nanolett.5b02900

## Beschreibung

Die Erfindung betrifft eine Vorrichtung und ein Verfahren zum Bereitstellen einer Vielzahl von Nanodrähten.

Es sind verschiedenste Anordnungen und Verfahren bekannt, mit denen Nanodrähte auf verschiedenste Weisen erhalten werden können. Beispielsweise können Nanodrähte über galvanische Prozesse oder mittels Verfahren, die aus der Dünnschichttechnologie bekannt sind, erhalten werden. Vielen bekannten Verfahren ist gemein, dass diese komplexe Maschinen erfordern und insbesondere deshalb üblicherweise nur in Labors bzw. Reinräumen eingesetzt werden (können). Insbesondere mangelt es an einer industrie-tauglichen Vorrichtung, die die Nanodrähte direkt auf beliebigen Strukturen und Oberflächen (z.B. Chips, printed circuit board (PCB), Sensoren, Batterien etc.) erzeugen kann, ohne in die Strukturen einzugreifen oder diese zu zerstören.

Auch haben viele bekannte Anordnungen und Verfahren den Nachteil, dass die erhaltenen Nanodrähte stark in ihren Eigenschaften und insbesondere hinsichtlich ihrer Qualität variieren. Regelmäßig unterscheiden sich die Nanodrähte aus verschiedenen Wachstumsvorgängen auch dann zum Teil erheblich, wenn die gleichen oder dieselben Maschinen, Ausgangsmaterialien und/oder Rezepte verwendet werden. Oft hängt die Qualität von Nanodrähten insbesondere von dem Können des Nutzers einer entsprechenden Anordnung bzw. des Anwenders eines entsprechenden Verfahrens, von Umwelteinflüssen und/oder auch schlicht vom Zufall ab. Erschwert wird all dies dadurch, dass es sich bei Nanodrähten um Strukturen handelt, die teilweise auch mit einem Lichtmikroskop nicht zu visualisieren sind. Daher können aufwendige Untersuchungen notwendig sein, um die beschriebenen Eigenschaften (und insbesondere die Schwankungen in diesen) überhaupt feststellen zu können.

Mit bekannten Verfahren und Anordnungen ist es insbesondere aufgrund der beschriebenen Qualitätsunterschiede oft nicht möglich, größere Flächen mit Nanodrähten zu bewachsen. So ist es wahrscheinlich, dass sich die Nanodrähte hinsichtlich ihrer Eigenschaften zwischen verschiedenen Bereichen einer größeren bewachsenen Fläche unterscheiden. Dies kann für viele Anwendungen nachteilig sein. Verfahren zur Herstellung von Nanodrähten sind beispielsweise bekannt aus der DE 10 2010 053 782 A1 sowie aus:
ROUSTAIE FAROUGH ET AL, "In situ synthesis of metallic nanowire arrays for ionization gauge electron sources", JOURNAL OF VACUUM SCIENCE & TECHNOLOGY B: MICROELECTRONICS AND NANOMETER STRUC-TURES, AMERICAN INSTITUTE OF PHYSICS, 2 HUNTINGTON QUAD-RANGLE, MELVILLE, NY 11747, vol. 34, no. 2, doi: 10.1116/1.4939756, ISSN 2166-2746, (20160112), (19010101), ARIANNA GAMBIRASI ET AL, "Direct electrodeposition of metal nanowires on electrode surface", ELECTROCHIMICA ACTA, ELSEVIER SCIENCE PUBLISHERS, BARKING, GB, vol. 56, no. 24, doi:10.1016/J.ELEC-TACTA.2011.07.045, ISSN 0013-4686, (20110713), pages 8582 - 8588, (20110723).

Hiervon ausgehend ist es Aufgabe der hier vorliegenden Erfindung, die im Zusammenhang mit dem Stand der Technik geschilderten technischen Probleme zu lösen bzw. zumindest zu verringern. Es soll insbesondere ein Verfahren vorgestellt werden, mit dem eine Vielzahl von Nanodrähten besonders großflächig und besonders zuverlässig bereitgestellt werden kann. Insbesondere soll ein Verfahren bereitgestellt werden, das einen industriellen Einsatz ohne zwingende Verwendung eines Reinraum-Labors ermöglicht. Darüber hinaus sollen eine Vorrichtung vorgestellt werden, mittels derer das Verfahren insbesondere gemäß der Anordnung besonders effizient durchgeführt werden kann.

Diese Aufgaben werden gelöst mit einer Vorrichtung und einem Verfahren gemäß den Merkmalen der unabhängigen Patentansprüche. Weitere vorteilhafte Ausgestaltungen der Vorrichtung sind in den jeweils abhängig formulierten Patentansprüchen angegeben. Die in den Patentansprüchen einzeln aufgeführten Merkmale sind in beliebiger, technologisch sinnvoller Weise miteinander kombinierbar und können durch erläuternde Sachverhalte aus der Beschreibung ergänzt werden, so lange diese Kombinationen und Varianten nicht über den Schutzumfang der Ansprüche hinausgehen.

Erfindungsgemäß wird ein Verfahren zum Bereitstellen einer Vielzahl von Nanodrähten vorgestellt, wobei das Verfahren auf der Benutzung der Vorrichtung nach Anspruch 1 beruht und zumindest die folgenden Verfahrensschritte umfasst:
a) Auflegen einer Folie auf eine Oberfläche, wobei die Folie eine Vielzahl von durchgehenden Poren aufweist, in denen die Nanodrähte gewachsen werden können,
b) Auflegen eines Mittels zum Bereitstellen eines Elektrolyten auf die Folie, und
c) galvanisches Wachsen der Vielzahl von Nanodrähten aus dem Elektrolyten.

Die angegebenen Verfahrensschritte werden vorzugsweise, aber nicht notwendigerweise, in der angegebenen Reihenfolge durchlaufen.

Unter einem Nanodraht (engl. "nanowire") wird hier jeder materielle Körper verstanden, der eine drahtähnliche Form und eine Größe im Bereich von wenigen Nanometern bis zu wenigen Mikrometern hat. Ein Nanodraht kann z.B. eine kreisförmige, ovale oder mehreckige Grundfläche aufweisen. Insbesondere kann ein Nanodraht eine hexagonale Grundfläche aufweisen. Vorzugsweise sind alle Nanodrähte aus dem gleichen Material gebildet.

Bevorzugt weisen die Nanodrähte eine Länge im Bereich von 100 nm [Nanometer] bis 100 µm [Mikrometer], insbesondere im Bereich von 500 nm bis 30 µm auf. Weiterhin weisen die Nanodrähte bevorzugt einen Durchmesser im Bereich von 10 nm bis 10 µm, insbesondere im Bereich von 30 nm bis 2 µm auf. Dabei bezieht sich der Begriff Durchmesser auf eine kreisförmige Grundfläche, wobei bei einer davon abweichenden Grundfläche eine vergleichbare Definition eines Durchmessers heranzuziehen ist. Es ist besonders bevorzugt, dass alle verwendeten Nanodrähte die gleiche Länge und den gleichen Durchmesser aufweisen.

Das beschriebene Verfahren ist für verschiedenste Materialien der Nanodrähte anwendbar. Als Material der Nanodrähte bevorzugt sind elektrisch leitende Materialien, insbesondere Metalle wie Kupfer, Silber, Gold, Nickel, Zinn und Platin. Aber auch nichtleitende Materialien wie Metalloxide sind bevorzugt.

Die Oberfläche, auf die die Nanodrähte gewachsen werden sollen, ist vorzugsweise elektrisch leitend ausgeführt. Sofern die Oberfläche Teil eines ansonsten nicht elektrische leitenden Körpers (wie z.B. eines Substrats ist), kann die elektrische Leitfähigkeit z. B. durch eine Metallisierung erreicht werden. So kann z. B. ein nicht elektrisch leitendes Substrat mit einer dünnen Schicht Metall überzogen werden. Durch die Metallisierung kann insbesondere eine Elektrodenschicht erzeugt werden. Je nach Material der Oberfläche und/oder der Elektrodenschicht kann es sinnvoll sein, eine Haftschicht zwischen der Oberfläche und der Elektrodenschicht vorzusehen, die eine Haftung zwischen der Oberfläche und der Elektrodenschicht vermittelt.

Durch die elektrische Leitfähigkeit der Oberfläche kann diese als Elektrode für das galvanische Wachstum der Nanodrähte genutzt werden. Das Substrat kann insbesondere ein Siliziumsubstrat sein. Die Oberfläche kann insbesondere die Oberfläche eines Körpers sein, der mit elektrisch leitenden Strukturen versehen ist. Das kann insbesondere ein Siliziumchip oder ein sogenanntes printed circuit board (PCB) sein.

Die Verfahrensschritte a) bis c) können zunächst in der angegebenen Reihenfolge durchlaufen werden. Anschließend können die Nanodrähte von der Oberfläche entfernt und an anderer Stelle weiterverwendet werden. Dies kann z. B. wie weiter unten beschrieben durch Entfernen der Folie erfolgen. Alternativ ist es bevorzugt, dass die Nanodrähte durch Abkratzen oder Abstreifen (z. B. mittels eines Messers oder einer Klinge) von der Oberfläche entfernt werden. Auch ist es bevorzugt, dass die Nanodrähte durch Abtupfen (z. B. mittels eines Tuchs) von der Oberfläche entfernt werden. In all den genannten Fällen können die Nanodrähte (an einem anderen Ort als der Oberfläche, auf die sie gewachsen wurden) weiterverwendet werden.

Wurden die Nanodrähte wie beschrieben entfernt, können anschließend die Verfahrensschritte a) bis c) erneut durchgeführt werden (sowie ein gegebenenfalls erneutes Entfernen von neuen Nanodrähten).

Die Folie ist vorzugsweise mit einem Kunststoffmaterial, insbesondere mit einem Polymermaterial gebildet. Insbesondere ist es bevorzugt, dass die Folie derart mit der der Oberfläche verbunden wird, dass die Folie nicht verrutscht. Dies könnte die Qualität der gewachsenen Nanodrähte mindern.

Dass die Poren der Folie durchgehend ausgeführt sind, ist vorzugsweise derart realisiert, dass die Poren von einer Oberseite der Folie zu einer Unterseite der Folie durchgehende Kanäle ausbilden. Insbesondere ist es bevorzugt, dass die Poren zylinderförmig ausgeführt sind. Es ist aber auch möglich, dass die Poren als Kanäle mit gekrümmtem Verlauf ausgeführt sind. Eine Pore kann z.B. eine kreisförmige, ovale oder mehreckige Grundfläche aufweisen. Insbesondere kann eine Pore eine hexagonale Grundfläche aufweisen. Vorzugsweise sind die Poren gleichmäßig ausgeführt (d.h. die Poren unterscheiden sich vorzugsweise nicht hinsichtlich der Größe, Form, Anordnung und/oder Abstand zu benachbarten Poren).

Werden die Nanodrähte in Schritt c) gewachsen, so werden die Poren vorzugsweise (insbesondere vollständig) mit dem galvanisch abgeschiedenen Material gefüllt. Dadurch erhalten die Nanodrähte die Größe, Form und Anordnung der Poren. Durch Wahl der Folie bzw. der Poren darin können also die Eigenschaften der zu wachsenden Nanodrähte festgelegt bzw. beeinflusst werden. Die Folie kann daher auch als "Template", "Templatefolie" oder "Schablone" bezeichnet werden.

Bei dem Mittel zum Bereitstellen des Elektrolyten kann es sich um jede Vorrichtung handeln, die dazu eingerichtet und bestimmt ist, einen Elektrolyten zumindest an einer Ausgabestelle abzugeben. Vorzugsweise ist die Ausgabestelle flächig ausgeführt, wobei besonders bevorzugt ist, dass der Elektrolyt über eine Ausgabefläche gleichmäßig ausgegeben werden kann. Weiterhin ist es bevorzugt, dass das Mittel zum Bereitstellen des Elektrolyten die Folie vollständig überdeckt. Beispielsweise kann es sich bei dem Mittel zum Bereitstellen des Elektrolyten um einen Schwamm, ein Tuch, einen porösen festen Körper oder aber auch um eine Einspritzeinrichtung mit einer oder mehreren Düsen handeln. Das Mittel zum Bereitstellen des Elektrolyten ist bevorzugt derart ausgeführt, dass es zusätzlich eine Fixierung der Folie bewirken kann. Das kann insbesondere dadurch realisiert sein, dass das Mittel zum Bereitstellen des Elektrolyten flächig ausgeführt ist und zum Anpressen der Folie an die Oberfläche bestimmt und eingerichtet ist.

Gemäß der Schritte a) bis c) entsteht vorzugsweise ein Schichtaufbau aus zumindest den drei Schichten: Oberfläche, Folie und Mittel zum Bereitstellen des Elektrolyten (die in der hier genannten Reihenfolge angeordnet sind). Dieser Schichtaufbau kann in jeder beliebigen räumlichen Orientierung verwendet werden. Bevorzugt ist jedoch eine Orientierung, bei der die Oberfläche unten und das Mittel zum Bereitstellen des Elektrolyten oben angeordnet sind.

In Schritt c) erfolgt schließlich unter Verwendung des beschriebenen Schichtaufbaus das Wachstum der Nanodrähte. Dabei kann insbesondere über die folgenden Parameter die Qualität der Nanodrähte beeinflusst werden:
- eine angelegte Spannung,
- eine vorliegende Stromdichte,
- ein zeitlicher Verlauf der Stromdichte und/oder der Spannung,
- ein Druck des Elektrolyten auf die Oberfläche,
- eine Zusammensetzung des Elektrolyten,
- ein Anpressdruck der Folie auf die Oberfläche, insbesondere durch Anpressen des Mittels zum Bereitstellen des Elektrolyten,
- ein zeitlicher Verlauf des Anpressdruckes der Folie,
- eine bei dem Verfahren vorliegende Temperatur,
- ein bei dem Verfahren verwendeter zeitlicher Temperaturverlauf, und
- eine Strömung bzw. Bewegung des Elektrolyten.

Bei der angelegten Spannung handelt es ich um eine zwischen Elektroden für das galvanische Wachstum angelegte Spannung. Bei der Stromdichte handelt es sich um den auf die zu bewachsende Fläche bezogenen Strom (Strom / Rasenfläche). Insbesondere können diese Parameter auch mit der Zeit verändert werden. Je nach verwendetem Material, Größe, Form, Dichte (d.h. mittlerem Abstand zwischen benachbarten Nanodrähten) und Anordnung der Nanodrähte können die optimalen Parameter variieren. Insbesondere eine zeitliche Veränderung der Stromdichte kann die Nanodrahtherstellung verbessern.

Bevorzugt wird das Verfahren für Kupfer bei Raumtemperatur durchgeführt. Die angelegte Spannung liegt bevorzugt zwischen 0,01 V und 2 V [Volt], insbesondere bei 0,2 V. Als die Galvanik für Kupfer ist insbesondere eine Mischung aus CuSO₄ [Kupfersulfat], H₂SO₄ [Schwefelsäure] und H₂O [Wasser] bevorzugt. Um unter diesen Bedingungen beispielsweise Nanodrähte aus Kupfer mit einem Durchmesser von 100 nm [Nanometer] und einer Länge von 10 µm [Mikrometer] zu erhalten, wird bevorzugt eine Stromdichte von 1,5 mA/cm² [Milliampere pro Quadratzentimeter] (Gleichstrom) über eine Wachstumsdauer von 20 Minuten verwendet. Um beispielsweise Nanodrähte aus Kupfer mit einem Durchmesser von 1 µm [Mikrometer] und einer Länge von 10 µm [Mikrometer] zu erhalten, wird bevorzugt eine Stromdichte von 0,5-2 mA/cm² [Milliampere pro Quadratzentimeter] (Gleichstrom) über eine Wachstumsdauer von 40 Minuten verwendet.

Vorzugsweise wird nach Abschluss des Wachstums der Nanodrähte in Schritt c) die Folie zumindest teilweise (besonders bevorzugt vollständig) entfernt. Damit können die Nanodrähte freigelegt werden, so dass sie zur weiteren Verwendung zur Verfügung stehen. Das Entfernen der Folie erfolgt vorzugsweise thermisch und/oder chemisch (z. B. mittels einer Lauge oder eines organischen Lösungsmittels) oder mittels Sauerstoffplasma.

In einer Ausführungsform ist es bevorzugt, dass zwei oder mehr Folien verwendet werden. Durch Aneinanderlegen mehrerer Folien können insbesondere Nanodrähte mit einer besonders großen Länge und/oder mit einer variablen geometrischen Form erhalten werden. Ebenfalls ist durch das Aneinanderlegen mehrerer Folien ein Prozessschritt möglich, bei dem durch Abziehen der äußersten Folie alle Nanodrähte auf eine gemeinsame Länge, die sich insbesondere aus der Dicke der an der Oberfläche anliegenden Folie ergibt, gekürzt werden.

Mit dem beschriebenen Verfahren, insbesondere unter Verwendung der als bevorzugt beschriebenen Parameter, können Nanodrähte besonders hoher Qualität erhalten werden. Auch können diese über eine besonders große Oberfläche besonders gleichmäßig hinsichtlich Länge, Durchmesser, Struktur, Dichte (d.h. mittleren Abstands zwischen benachbarten Nanodrähten) und Materialzusammensetzung gewachsen werden. Auch ist das beschriebene Verfahren nicht auf den Einsatz in einem Labor beschränkt, da es insbesondere ohne Mikromontage-Handhabung auskommt. Verfahren, die beispielswiese mit Schwerionen-Beschuss arbeiten, sind auf eine Forschungseinrichtung beschränkt, da ein Ionenbeschleuniger eine feststehende Großanlage ist.

In einer bevorzugten Ausführungsform des Verfahrens wird eine Strukturierungsschicht zwischen der Oberfläche und der Folie bereitgestellt, wobei die Strukturierungsschicht mindestens eine Auslassung aufweist an einer Stelle der Oberfläche, an der die Nanodrähte auf die Oberfläche gewachsen werden sollen.

Mit der Strukturierungsschicht kann erreicht werden, dass die Nanodrähte nur in festlegbaren Bereichen der Oberfläche gewachsen werden. Diese Bereiche werden durch die mindestens eine Auslassung definiert. Vorzugsweise wird die mindestens eine Auslassung in der Strukturierungsschichtschicht durch eine fotolithographische Strukturierung erzeugt. Würde auf die Strukturierungsschichtschicht verzichtet, würden die Nanodrähte auf der gesamten Oberfläche erzeugt.

Bei der Strukturierungsschicht handelt es sich vorzugsweise um eine Schicht aus einem nicht elektrisch leitenden Material. Die Strukturierungsschichtschicht kann entweder vor Schritt a) auf die Oberfläche aufgebracht werden oder es kann eine Oberfläche mit bereits darauf befindlicher Strukturierungsschicht bereitgestellt werden. In dieser Ausführungsform erfolgt das Anlegen der Folie an die Oberfläche in Schritt a) durch Anlegen der Folie an die Strukturierungsschicht. Die Oberfläche und die Folie kommen insoweit jedenfalls außerhalb der mindestens einen Auslassung nicht unmittelbar sondern nur mittelbar (über die Strukturierungsschicht) in Kontakt.

Werden Nanodrähte auf der Oberfläche gewachsen und anschließend entfernt (insbesondere zur Verwendung an anderer Stelle), kann die Oberfläche zum Wachsen weiterer Nanodrähte wiederverwendet werden. In dem Fall kann die Strukturierungsschicht auf der Oberfläche belassen werden und eine (neue) Folie an die Strukturierungsschicht angelegt werden. Auch dies soll als ein Bereitstellen einer Strukturierungsschicht zwischen der Oberfläche und der Folie verstanden werden. Das bedeutet insbesondere, dass eine einmal mit einer Strukturierungsschicht versehene Oberfläche zu mehrmaligem Wachstum von Nanodrähten gemäß der Verfahrensschritte a) bis c) verwendet werden kann.

Die Strukturierungsschicht ist bevorzugt als eine Laminierschicht ausgebildet. Dabei meint Laminierschicht, dass die Strukturierungsschicht durch erweichen eines Kunststoffmaterials (insbesondere eines Polymermaterials) auf die Oberfläche aufgebracht wird. Die Strukturierungsschicht ist dabei bevorzugt mit Polymeren gebildet. Bevorzugt dient die Strukturierungsschicht auch dazu, die Position der Folie zu fixieren. Insbesondere in der alternativen Ausführungsform, in der die Strukturierungsschicht die Position der Folie nicht fixiert, kann die Strukturierungsschicht auch mit weiteren elektrisch isolierenden Materialien wie zum Beispiel Siliziumdioxid oder Siliziumnitrid gebildet sein.

Die Strukturierungsschicht weist bevorzugt eine Dicke von 200 nm [Nanometer] bis 10 mm [Millimeter] auf. Die Dicke der Strukturierungsschicht wird bevorzugt insbesondere in Abhängigkeit des Materials der Strukturierungsschicht gewählt. Ist die Strukturierungsschicht als eine Laminierschicht ausgeführt, kann die Folie durch Lamination auf der Oberfläche fixiert werden.

Durch die Wahl der Anzahl, Position, Größe und Gestalt der mindestens einen Auslassung in der Strukturierungsschicht kann gesteuert werden, in welchen Bereichen der Oberfläche die Nanodrähte gewachsen werden sollen. Dies ist insbesondere dadurch möglich, dass die Strukturierungsschicht nicht elektrisch leitend ausgeführt ist, so dass eine galvanische Abscheidung (und damit ein galvanisches Wachstum der Nanodrähte) auf das Material der Strukturierungsschicht nicht möglich ist. Dabei weist jede Auslassung vorzugsweise eine Ausdehnung auf, die groß ist im Vergleich zu einem mittleren Durchmesser der Nanodrähte und zu einem mittleren Abstand zwischen benachbarten Nanodrähten. Das bedeutet insbesondere, dass innerhalb jeder Auslassung jeweils eine Vielzahl von Nanodrähten gewachsen werden kann.

Es ist bevorzugt, dass die Folie derart auf die Strukturierungsschicht aufgelegt wird, dass die Folie zumindest teilweise die mindestens eine Auslassung in der Strukturierungsschicht überdeckt. Dadurch kann sichergestellt werden, dass zumindest in diesem Bereich der Überlappung ein Wachstum der Nanodrähte stattfinden kann. Weiterhin ist es bevorzugt, dass die Folie zumindest teilweise auch die Strukturierungsschicht in einem Bereich überdeckt, in dem die Strukturierungsschicht keine Auslassung aufweist. Dadurch kann sichergestellt werden, dass die Folie in ihrer Position fixiert ist. Die Fixierung kann auch durch das Mittel zum Bereitstellen des Elektrolyten sichergestellt werden.

Es ist bevorzugt, aber nicht notwendig, dass die Strukturierungsschicht die gesamte Oberfläche überdeckt und dass die Folie die gesamte Strukturierungsschicht überdeckt.

Als Alternative zum Laminierungsverfahren kann die Strukturierungsschicht durch einen Fotolack erzeugt werden, der durch einen Lithographie Prozess (Belichten mit einer Maske) mit der entsprechenden Strukturierung versehen wird und nach dem Entwickeln dann die Auslassungen freigibt auf denen dann die Nanodrähte gemäß Schritt a) bis c) gewachsen werden. In einer bevorzugten Variante dient der Fotolack aus als Laminierschicht.

In diesen Ausführungsformen entsteht vorzugsweise ein Schichtaufbau aus zumindest den vier Schichten: Oberfläche, Strukturierungsschicht, Folie und Mittel zum Bereitstellen des Elektrolyten (die in der hier genannten Reihenfolge angeordnet sind). Zusätzlich können auch die weiter oben beschriebene Elektrodenschicht (insbesondere bei einer elektrisch nicht leitenden Oberfläche) und gegebenenfalls auch eine Haftschicht in dem Schichtaufbau enthalten sein. So kann der Schichtaufbau insbesondere die folgenden sechs Schichten umfassen: Oberfläche, Haftschicht (die insbesondere elektrisch leitend sein kann), Elektrodenschicht (die elektrisch leitend ist), Strukturierungsschicht (die isolierende flächig ausgeführt sein kann), Folie und Mittel zum Bereitstellen des Elektrolyten. Die Elektrodenschicht stellt dann die Gegenelektrode für den galvanischen Prozess (Schritt c)) dar, die alternativ durch die Oberfläche selber gebildet wird.

In einer weiteren bevorzugten Ausführungsform des Verfahrens findet das Verfahren zumindest teilweise unter Erwärmung statt.

Die Erwärmung findet vorzugsweise in Schritt c) statt. Dabei werden bevorzugt die in der folgenden Tabelle für die verschiedenen Materialien der Nanodrähte angegebenen bevorzugten beziehungsweise besonders bevorzugten Temperaturen verwendet.

| .Material der | Bevorzugte | besonders bevorzugte |
|---|---|---|
| Nanodrähte | Temperatur | Temperatur |
| Kupfer | 13°...43° | 18°...28° |
| Silber | 50°...70° | 55°...65° |
| Platin | 50°...70° | 55°...65° |
| Gold | 50°...70° | 55°...65° |
| Nickel | 35°... 55° | 40°... 50° |
| Zinn | 13°...43° | 18°...28° |

Durch eine erhöhte Temperatur kann die Mobilität der Ionen im Elektrolyten erhöht werden. Damit kann das Wachstum der Nanodrähte begünstigt werden.

In einer weiteren bevorzugten Ausführungsform des Verfahrens wird der Elektrolyt dem Mittel zum Bereitstellen des Elektrolyten nach Bedarf zugeführt.

Der Elektrolyt wird dem Mittel zum Bereitstellen des Elektrolyten vorzugsweise über ein Rohr zugeführt. Der Bedarf an dem Elektrolyten ergibt sich insbesondere aus dem Verbrauch durch die galvanische Abscheidung. Steht am Ort des Wachstums der Nanodrähte zu wenig Elektrolyt zur Verfügung, so können sich Fehlstellen innerhalb der Nanodrähte bilden bzw. es können Bereiche entstehen, in denen keine Nanodrähte vorhanden sind. Weiterhin kann bei einem ungleichmäßig verteilten Elektrolyten, bei einer ungleichmäßigen Ionenkonzentration des Elektrolyten und/oder bei einer ungleichmäßigen Temperatur des Elektrolyten eine ungleichmäßige Wachstumsrate auftreten. Eine ungleichmäßige Wachstumsrate kann dazu führen, dass die Nanodrähte ungleichmäßig wachsen. Wird die zugeführte Menge des Elektrolyten also genau an den Verbrauch angepasst, können Nanodrähte besonders hoher Qualität und Homogenität erhalten werden. Insbesondere kann auch auf eine Abdichtung z. B. einer Elektrolysezelle (in der das Verfahren beispielsweise durchgeführt werden kann) verzichtet werden, wenn der Elektrolyt nicht derart überschüssig vorhanden ist, dass dieser unkontrolliert aus dem Mittel zum Bereitstellen des Elektrolyten austritt.

In einer weiteren bevorzugten Ausführungsform des Verfahrens wird das Mittel zum Bereitstellen des Elektrolyten zumindest zeitweise an die Folie gepresst.

Bevorzugt findet das Anpressen des Mittels zum Bereitstellen des Elektrolyten an die Folie während Schritt c) statt. Dies kann insbesondere während des gesamten Schritts c) erfolgen, bevorzugt jedoch nur in einer Anfangsphase des Nanodraht-Wachstums. Auch ein Anpressen bereits in Schritt c) ist bevorzugt. Durch das Anpressen des Mittels zum Bereitstellen des Elektrolyten an die Folie kann das Bereitstellen des Elektrolyten erleichtert werden. Beispielsweise kann der Elektrolyt aus einem Schwamm durch Pressen dieses Schwamms zum Austreten angeregt werden. Vorzugsweise ist zum Anpressen eine Feder vorgesehen, wobei die Kraft, mit der die Feder das Mittel zum Bereitstellen des Elektrolyten an die Folie presst, einstellbar ist. Auch können elastische oder plastische Elemente, motorische, hydraulische und/oder pneumatische Verstell-Einheiten oder Hebelmechanismen zum Erzeugen der Anpresskraft verwendet werden. Durch Einstellen der Kraft kann die ausgegebene Menge an Elektrolyt kontrolliert werden. Weiterhin kann durch das Anpressen der Folie auf die Oberfläche beziehungsweise auf die Strukturierungsschicht sichergestellt werden, dass die Folie formschlüssig, ortsfest und frei von Lufteinschlüssen (zwischen der Folie und der Oberfläche beziehungsweise Strukturierungsschicht sowie in den Kanälen innerhalb der Folie) gehalten wird. Eine besonders gleichmäßige Elektrolytverteilung kann auch durch Bewegen des Mittels zum Bereitstellen des Elektrolyten während des Verfahrens sichergestellt werden. Die Bewegung kann dabei beispielsweise rotatorisch, horizontal und/oder vertikal erfolgen. Insbesondere ist es bevorzugt, dass das Mittel zum Bereitstellen des Elektrolyten mit einem zeitlich veränderlichen Druck an die Folie gepresst wird oder nach einer ersten Wachstumsphase von der Folie abgehoben wird und so ein optionales Verschließen von einzelnen Poren verhindert wird.

In einer weiteren bevorzugten Ausführungsform wird kontinuierlich frischer Elektrolyt dem Mittel zum Bereitstellen zugeführt und gleichzeitig überschüssiger Elektrolyt abgeführt. Dadurch wird eine Strömung des Elektrolyts erzwungen, die eine ausreichende Ionenzufuhr gewährleistet. Die Strömung kann auch durch Zirkulieren des Elektrolyts erreicht werden.

In einer weiteren bevorzugten Ausführungsform wird der Anpressdruck mit einem Messmittel überwacht und geregelt. Die Regelung kann insbesondere mit einem Regelglied erfolgen. Durch die Regelung kann insbesondere der Anpressdruck über die (vorzugsweise gesamte) Prozesszeit bestmöglich entsprechend vorgebbarer Werte eingestellt werden.

In einer weiteren bevorzugten Ausführungsform des Verfahrens ist das Mittel zum Bereitstellen des Elektrolyten schwammartig ausgeführt.

Unter einer schwammartigen Ausführung ist zu verstehen, dass das Mittel zum Bereitstellen des Elektrolyten dazu eingerichtet ist, den Elektrolyten zunächst aufzunehmen (insbesondere aufzusaugen), zu speichern und bei Bedarf (insbesondere unter Druck) wieder abzugeben. Als ein schwammartig ausgeführtes Mittel zum Bereitstellen des Elektrolyten sind bevorzugt:
- ein Schwamm (z. B. aus einem Schaumstoffmaterial, vorzugsweise einem Melaminschaum und/oder Teflonschaum),
- ein Tuch (z. B. aus Mikrofaser, Filterpapier, Baumwolle und/oder einem anderen Stoff) und
- ein poröser fester Körper (wie z. B. ein poröser Stein, ein poröses Glas und/oder ein Keramikschaum).

Besonders bevorzugt ist das Mittel zum Bereitstellen des Elektrolyten flexibel ausgeführt. Damit kann erreicht werden, dass das Mittel zum Bereitstellen des Elektrolyten den Elektrolyten unter Druck besonders gut abgeben kann. Auf diese Weise kann sichergestellt werden, dass jede Pore der Folie mit einer ausreichenden Menge des Elektrolyten versorgt wird. Auch kann ein solches Mittel zum Bereitstellen des Elektrolyten besonders gut an die Folie angepresst werden. Auch kann so eine Beschädigung der Folie verhindert werden.

In einer weiteren bevorzugten Ausführungsform des Verfahrens sind die durchgehenden Poren der Folie senkrecht zu der Oberfläche ausgeführt.

In dieser Ausführungsform können die Nanodrähte senkrecht zu der Oberfläche gewachsen werden. Dies ist für viele Anwendungen sinnvoll.

In einer weiteren bevorzugten Ausführungsform des Verfahrens wird zum galvanischen Wachsen der Vielzahl von Nanodrähten eine Spannung zwischen der zu bewachsenden Oberfläche und einer an dem Mittel zum Bereitstellen des Elektrolyten anliegenden Elektrode angelegt.

Als eine Elektrode kommt hier die elektrisch leitende Oberfläche (ggf. unter Berücksichtigung der weiter oben bereits beschriebenen Möglichkeit einer insbesondere durch Metallisierung erhaltbaren Elektrodenschicht) in Betracht. Die Elektrodenschicht ist bevorzugt durchgängig und geschlossen auf der Oberfläche ausgeprägt. Vorteilhafter weise werden für die Elektrodenschicht wahlweise Kupfer, Gold, Silber und/oder Aluminium verwendet. Wird die Oberfläche als eine Elektrode für das Wachstum der Nanodrähte verwendet, kann so ein homogenes elektrisches Feld über der gesamten Oberfläche erzeugt werden. Die zweite Elektrode ist vorzugsweise flächig ausgeführt, insbesondere derart, dass die zweite Elektrode das Mittel zum Bereitstellen des Elektrolyten zumindest teilweise (vorzugsweise vollständig) überdeckt. In dem Fall stellt die zweite Elektrode eine siebte Schicht in dem weiter oben beschriebenen Schichtaufbau dar: Oberfläche, Haftschicht, Elektrodenschicht, Strukturierungsschicht, Folie, Mittel zum Bereitstellen des Elektrolyten und zweite Elektrode. Die Oberfläche oder die Elektrodenschicht stellt dabei die erste Elektrode dar.

In einer weiteren bevorzugten Ausführungsform umfasst das Verfahren weiterhin die Verfahrensschritte:
d) Entfernen der Folie von der Oberfläche einschließlich der in der Folie eingeschlossenen Vielzahl der Nanodrähte, und
e) Aufbringen der Folie auf eine Zieloberfläche, wobei die in der Folie eingeschlossene Vielzahl der Nanodrähte mit der Zieloberfläche verbunden wird.

Die angegebenen Verfahrensschritte d) und e) werden vorzugsweise, aber nicht notwendigerweise, in der angegebenen Reihenfolge durchlaufen. Weiterhin ist es bevorzugt, die Verfahrensschritte d) und e) nach Durchlaufen der Verfahrensschritte a) bis c) (ebenfalls vorzugsweise in deren angegebener Reichenfolge) zu durchlaufen.

Wie bereits weiter oben beschrieben, kann es von Vorteil sein, die Nanodrähte zunächst auf einer Oberfläche zu wachsen und die Nanodrähte dann zur weiteren Verwendung auf eine andere Oberfläche (hier die Zieloberfläche) zu transferieren. Dazu bietet diese Ausführungsform eine bevorzugte Möglichkeit.

In einer weiteren bevorzugten Ausführungsform werden die gewachsenen Nanodrähte zumindest zeitweise durch Aufbringen einer Schutzschicht gegen Oxidieren und/oder Verkleben der Nanodrähte geschützt.

Die Schutzschicht kann insbesondere einen Schutzlack umfassen. Bevorzugt ist die Schutzschicht mit einem elektrisch nicht leitenden Material gebildet. Die Schutzschicht kann insbesondere für einen Transport und/oder eine Lagerung der Nanodrähte aufgebracht werden.

In einer weiteren bevorzugten Ausführungsform des Verfahrens wird die Folie zumindest teilweise aufgelöst.

Vorzugsweise findet das Auflösen der Folie am Ende des Verfahrens statt, d.h. insbesondere nach Schritt c). Das Entfernen der Folie ist allgemein vorteilhaft, weil erst durch das Entfernen der Folie die Nanodrähte freigelegt werden. Bevorzugt wird die Folie vollständig aufgelöst. Damit können für eine spätere Verwendung der Nanodrähte ungewünschte Rückstände der Folie vermieden werden. Die Folie kann thermisch und/oder chemisch entfernt werden. Zum chemischen Entfernen ist es bevorzugt, die Folie einem (insbesondere organischen) Lösungsmittel, einer Lauge und/oder einem Plasma auszusetzen.

In einer weiteren bevorzugten Ausführungsform des Verfahrens weist die Oberfläche eine Mehrzahl von elektrisch leitenden Bereichen auf. Vor Schritt a) werden die folgenden Verfahrensschritte durchgeführt:
i) Aufbringen einer elektrisch leitenden Haftschicht auf die Oberfläche (insbesondere eines Substrates),
ii) Aufbringen einer elektrisch leitenden Elektrodenschicht auf die Oberfläche,
iii) Aufbringen einer elektrisch isolierenden Strukturierungsschicht auf die elektrisch leitende Elektrodenschicht, und
iv) Freilegen der elektrisch leitenden Bereiche der Oberfläche an den Stellen, an denen die Nanodrähte auf die elektrisch leitenden Bereiche gewachsen werden sollen, wobei eine elektrisch leitende Verbindung zwischen den elektrisch leitenden Bereichen und der elektrisch leitenden Elektrodenschicht erhalten bleibt.

Nach Schritt c) werden die folgenden Verfahrensschritte durchgeführt:
α) Entfernen der Folie,
β) Entfernen der Strukturierungsschicht,
γ) Entfernen der Elektrodenschicht und
Δ) Entfernen der elektrisch leitenden Haftschicht

Mit dieser Ausführungsform können Nanodrähte insbesondere auf Oberflächen mit elektrisch leitenden Strukturen besonders einfach gewachsen werden. Insbesondere kann es sich dabei um sogenannte printed circuit boards (PCB's) oder Silizium-Chips handeln. Diese weisen regelmäßig eine Oberfläche auf, die grundsätzlich elektrisch isolierend ist und auf der beispielsweise Kontaktpunkte und Leiterbahnen als elektrisch leitende Strukturen vorgesehen sind. Solche Kontaktpunkte sind ein Beispiel für die hier beschriebenen elektrisch leitenden Bereiche der zu bewachsenden Oberfläche. Bevorzugt ist, dass die elektrisch leitenden Bereiche der Oberfläche zunächst voneinander elektrisch isoliert sind. Das kann insbesondere durch eine Grundstrukturierungsschicht (die von der weiter vorne beschriebenen Strukturierungsschicht zu unterscheiden ist) erreicht werden, die elektrisch isolierend ausgeführt ist und die Auslassungen an den Stellen der elektrisch leitenden Bereiche aufweist. Um nach dem beschriebenen Verfahren Nanodrähte auf derartigen elektrisch leitenden Bereichen zu wachsen, ist es vorteilhaft, wenn die elektrisch leitenden Bereiche als Elektrode des galvanischen Wachstums verwendet werden können. Daher ist es bevorzugt, dass zumindest für die Dauer des beschriebenen Verfahrens eine elektrisch leitende Verbindung zwischen den zunächst voneinander getrennten elektrisch leitenden Bereichen der Oberfläche hergestellt wird. Das kann grundsätzlich dadurch erfolgen, dass jeder der elektrisch leitenden Bereiche einzeln kontaktiert wird, beispielsweise über eine Nadel. Insbesondere für eine Vielzahl von elektrisch leitenden Bereichen kann dies aber aufwendig sein. Die vorliegende Ausführungsform bietet eine besonders einfache Möglichkeit, auch eine große Zahl von elektrisch leitenden Bereichen miteinander zu verbinden und so deren Kontaktierung erheblich zu vereinfachen.

In Schritt i) wird eine Haftschicht aufgebracht. Das ist derart zu verstehen, dass eine Schicht aus einem elektrisch leitenden Material, insbesondere aus einem Metall, vorteilhafterweise Chrom, Titan oder Wolfram beispielsweise mittels CVD (chemical vapor deposition) oder PVD (physical vapor deposition), über die gesamte Grundstrukturierungsschicht einschließlich der Auslassungen ausgebildet wird. Insbesondere ist es bevorzugt, dass die elektrisch leitende Haftschicht in die Auslassungen der Grundstrukturierungsschicht hinein ausgebildet wird und insbesondere auch an Kanten der Auslassungen ausgebildet wird. Damit ist gemeint, dass die elektrisch leitende Haftschicht derart durchgehend ausgebildet wird, dass eine elektrisch leitende Verbindung zwischen den elektrisch leitenden Bereichen, bevorzugt zwischen allen elektrisch leitenden Bereichen, hergestellt wird. Damit können die elektrisch leitenden Bereiche beispielsweise durch Kontaktieren der elektrisch leitenden Haftschicht kontaktiert werden. Bevorzugt erfolgt das Kontaktieren über die in Schritt ii) aufgebrachte Elektrodenschicht. Die elektrisch leitenden Bereiche können so gemeinsam als Elektrode für das galvanische Wachstum der Nanodrähte verwendet werden. Weiterhin sorgt die Haftschicht dafür, dass der anschließende Schichtaufbau mechanisch auf dem Substrat verankert wird und es auch unter Zug und Scherkräften, wie auch Temperaturwechseln nicht zu Ablösungen des Schichtaufbaus von der Oberfläche kommt.

In Schritt ii) wird eine elektrisch leitende Elektrodenschicht auf die Haftschicht aufgebracht. Das ist derart zu verstehen, dass eine Schicht aus einem elektrisch leitenden Material, insbesondere aus einem Metall, vorteilhafter weise Kupfer, Gold, Aluminium, Chrom, Titan über die gesamte Haftschicht einschließlich der Auslassungen der Grundstrukturierungsschicht ausgebildet wird. Insbesondere ist es bevorzugt, dass die elektrisch leitende Elektrodenschicht in die Auslassungen hinein ausgebildet wird und insbesondere auch an Kanten der Auslassungen ausgebildet wird. Damit ist gemeint, dass die elektrisch leitende Elektrodenschicht derart durchgehend ausgebildet wird, dass eine elektrisch leitende Verbindung zwischen den elektrisch leitenden Bereichen, bevorzugt zwischen allen elektrisch leitenden Bereichen, hergestellt wird. Damit können die elektrisch leitenden Bereiche insbesondere auch durch Kontaktieren der elektrisch leitenden Elektrodenschicht kontaktiert werden. Die elektrisch leitenden Bereiche können so gemeinsam als Elektrode für das galvanische Wachstum der Nanodrähte verwendet werden.

In Schritt iii) wird die Strukturierungsschicht auf die Elektrodenschicht aufgebracht und die Auslassungen aus der Strukturierungsschicht werden in Schritt iv) ausgebildet. Dabei ist es bevorzugt, dass jedem der elektrisch leitenden Bereiche (Kontakte) genau eine Auslassung zugeordnet ist. Insbesondere ist es bevorzugt, dass die elektrisch leitenden Bereiche die jeweils entsprechende Auslassung vollständig überlappen. Die elektrisch leitenden Bereiche sind also bevorzugt größer als die jeweils entsprechende Auslassung der Strukturierungsschicht. Es ist auch möglich, dass ein elektrisch leitender Bereich mehreren Auslassungen zugeordnet ist, so dass also innerhalb dieses elektrisch leitenden Bereichs mehrere Auslassungen vorgesehen sind.

Würde das Wachstum der Nanodrähte nach Auftragen der elektrisch leitenden Elektrodenschicht durchgeführt, würden die Nanodrähte auf der elektrisch leitenden Elektrodenschicht wachsen. Durch das Aufbringen der elektrisch isolierenden Strukturierungsschicht in Schritt iii) kann dies unterdrückt werden. Bevorzugt wird die elektrisch isolierende Strukturierungsschicht in Schritt iii) derart auf die elektrisch leitende Elektrodenschicht aufgebracht, dass die elektrisch isolierende Strukturierungsschicht die elektrisch leitende Elektrodenschicht vollständig überdeckt. Auch bei der elektrisch isolierenden Strukturierungsschicht ist es bevorzugt, dass die Kanten der Auslassungen der Elektrodenschicht überdeckt werden. Damit ist gemeint, dass nach Aufbringen der elektrisch isolierenden Strukturierungsschicht vorzugsweise keine Bereiche der elektrisch leitenden Elektrodenschicht freiliegen. Dadurch ist ein Kontaktieren der elektrisch leitenden Elektrodenschicht zunächst nicht möglich.

In Schritt iv) werden die Stellen der elektrisch leitenden Bereiche der Elektrodenschicht freigelegt, an denen die Nanodrähte gewachsen werden sollen. Das bedeutet insbesondere, dass die elektrisch isolierende Strukturierungsschicht an diesen Stellen entfernt wird. Das kann insbesondere durch lithografische Verfahren und unter Verwendung von Chemikalien erfolgen, die selektiv nur die elektrisch isolierende Strukturierungsschicht entfernen.

Bevorzugt liegt nach Schritt iv) ein Zwischenprodukt (beispielhaft ein SiliziumChip mit darauf angeordnetem Schichtaufbau) vor, das folgendes Umfasst:
- eine Oberfläche mit einer Mehrzahl von elektrisch leitenden Bereichen,
- eine auf die Oberfläche aufgebrachte durchgängige Haftschicht die eine durchgängige elektrisch leitende Oberfläche als Haftvermittler bereitstellt,
- eine auf die Haftschicht aufgebrachte elektrisch leitende Elektrodenschicht, die als erste Elektrode dient (bzw. die die elektrisch leitenden Bereiche miteinander verbindet, die als Elektroden dienen),
- eine auf die elektrisch leitende Elektrodenschicht aufgebrachte elektrisch isolierende Strukturierungsschicht, die Auslassungen an den Stellen aufweist, an denen die Nanodrähte gewachsen werden sollen,
wobei die elektrisch leitende Haftschicht und die elektrisch leitende Elektrodenschicht derart ausgeführt sind, dass die elektrisch leitenden Bereiche der Oberfläche über die elektrisch leitende Schicht elektrisch leitend miteinander verbunden sind, und dass nur die Stellen der elektrisch leitenden Bereiche, an denen die Nanodrähte gewachsen werden sollen, freiliegen.

Auf die Haftschicht kann verzichtet werden. Das ist insbesondere dann der Fall, wenn beispielsweise ein PCB verwendet wird, dessen zu bewachsende Bereiche derart vorbereitet sind, dass die zu wachsenden Nanodrähte bereits eine ausreichende mechanische Haftung haben. Die (vorzugsweise) metallischen Nanodrähte können damit direkt auf der bereitgestellten Oberfläche des PCBs gewachsen werden. Die Schritte i) und Δ) entfallen dabei. Entsprechend ist die Ausführungsform des beschriebenen Verfahrens bevorzugt, in der die Oberfläche eine Mehrzahl von elektrisch leitenden Bereichen aufweist und in der vor Schritt a) die folgenden Verfahrensschritte durchgeführt werden:
ii) Aufbringen einer elektrisch leitenden Elektrodenschicht auf die Oberfläche,
iii) Aufbringen einer elektrisch isolierenden Strukturierungsschicht auf die elektrisch leitende Elektrodenschicht, und
iv) Freilegen der elektrisch leitenden Bereiche der Oberfläche an den Stellen, an denen die Nanodrähte auf die elektrisch leitenden Bereiche gewachsen werden sollen, wobei eine elektrisch leitende Verbindung zwischen den elektrisch leitenden Bereichen und der elektrisch leitenden Elektrodenschicht erhalten bleibt.

Nach Schritt c) werden die folgenden Verfahrensschritte durchgeführt:
α) Entfernen der Folie,
β) Entfernen der Strukturierungsschicht, und
γ) Entfernen der Elektrodenschicht.

Die Beschreibung der Ausführungsform mit Haftschicht gilt hier entsprechend. In diesem Fall liegt nach Schritt iv) bevorzugt ein alternatives Zwischenprodukt (beispielhaft ein PCB mit darauf angeordnetem Schichtaufbau) vor, das folgendes umfasst:
- eine Oberfläche mit einer Mehrzahl von elektrisch leitenden Bereichen,
- eine auf die Oberfläche aufgebrachte elektrisch leitende Elektrodenschicht, die als erste Elektrode dient (bzw. die die elektrisch leitenden Bereiche miteinander verbindet, die als Elektroden dienen),
- eine auf die elektrisch leitende Elektrodenschicht aufgebrachte elektrisch isolierende Strukturierungsschicht, die Auslassungen an den Stellen aufweist, an denen die Nanodrähte gewachsen werden sollen,
wobei die elektrisch leitende Elektrodenschicht derart ausgeführt ist, dass die elektrisch leitenden Bereiche der Oberfläche über die elektrisch leitende Schicht elektrisch leitend miteinander verbunden sind, und dass nur die Stellen der elektrisch leitenden Bereiche, an denen die Nanodrähte gewachsen werden sollen, freiliegen.

Für das Wachstum der Nanodrähte können die elektrisch leitenden Bereiche der Oberfläche oder der Elektrodenschicht als Elektrode verwendet werden. Weil die elektrisch leitenden Bereiche über die elektrisch leitende Schicht miteinander verbunden sind, kann dabei ein einzelnes Kontaktieren der elektrisch leitenden Elektrodenschicht ausreichen. Dazu ist es bevorzugt, dass die elektrisch isolierende Strukturierungsschicht an mindestens einer Stelle entfernt wird (oder an dieser Stelle gar nicht erst auf die elektrisch leitende Elektrodenschicht aufgebracht wird), so dass die elektrisch leitende Elektrodenschicht an dieser Stelle beispielsweise mit einer Nadel kontaktiert werden kann. Auch kann die elektrisch leitende Elektrodenschicht dadurch kontaktiert werden, dass die elektrisch isolierende Strukturierungsschicht mit einer Nadel durchstoßen wird.

Mit dem so durch die Schritte i) bis iv) (bzw. ii) bis iv)) erhaltenen Zwischenprodukt wird bevorzugt das Wachstum der Nanodrähte gemäß den Schritten a) bis c) des beschriebenen Verfahrens durchgeführt. Die Nanodrähte werden dabei in den gemäß Schritt iv) freigelegten Stellen der elektrisch leitenden Bereiche gewachsen. Nachdem die Drähte gewachsen sind, wir die Folie in Schritt α) entfernt. Das kann wie zuvor beschrieben thermisch und/oder chemisch erfolgen. Anschließend werden in den Schritten β) und γ) auch die elektrisch leitende Elektrodenschicht und die elektrisch isolierende Strukturierungsschicht entfernt. Das erfolgt bevorzugt unter Verwendung von Chemikalien, die insbesondere derart ausgewählt sind, dass diese selektiv nur die elektrisch leitende Elektrodenschicht bzw. die elektrisch isolierende Strukturierungsschicht entfernen, während insbesondere die elektrisch leitenden Bereiche der Oberfläche und die Nanodrähte von den Chemikalien nicht angegriffen werden. Alternativ können auch Chemikalien eingesetzt werden die mehrere Schichten gleichzeitig (also insbesondere die Haftschicht, die Elektrodenschicht und/oder die Strukturierungsschicht) entfernen. Das ist insbesondere dadurch möglich, dass vorteilhafterweise die Chemikalien nicht die metallischen Nanodrähte angreifen und/oder dadurch, dass die Schichtdicken so gewählt sind, dass das Auf- oder Ablösen der Schichten schneller erfolgt als ein Auflösen oder Angreifen der Nanodrähte (die insbesondere dicker ausgeführt sein können als die zu entfernenden Schichten). Auf diese besonders bevorzugte Weise kann mit einem Schritt der gesamte Schichtaufbau entfernt und die Nanodrähte freigelegt werden.

In einer weiteren bevorzugten Ausführungsform des Verfahrens wird die Folie nach Durchführung der Schritte a) bis c) einschließlich der gewachsenen Nanodrähte entfernt. Anschließend werden die Schritte a) bis c) erneut durchgeführt. Die Schritte α) bis γ) (und gegebenenfalls Δ)) werden nach der erneuten Durchführung der Schritte a) bis c) durchgeführt.

Insbesondere durch Unebenheiten der elektrisch leitenden Bereiche kann es beim Wachstum der Nanodrähte vorkommen, dass die Nanodrähte ungleichmäßig hoch wachsen. Damit ist gemeint, dass die von der Oberfläche entfernten Enden der Nanodrähte nach Abschluss des Wachstums in unterschiedlichen Abständen von der Oberfläche angeordnet sind. Mit der vorliegenden Ausführungsform können Nanodrähte erhalten werden, die besonders gleichmäßig hoch gewachsen sind. Dazu kann insbesondere von einem der zuvor beschriebenen Zwischenprodukte ausgegangen werden. Gemäß den Schritten a) bis c) des beschriebenen Verfahrens werden darauf Nanodrähte gewachsen. Bei diesen Nanodrähten handelt es sich nicht um die Nanodrähte, die nach Abschluss des Verfahrens auf der Oberfläche verbleiben und auf deren Wachstum das beschriebene Verfahren gerichtet ist. Stattdessen handelt es sich um hilfsweise gewachsene Nanodrähte. Nach Wachstum der hilfsweise gewachsenen Nanodrähte wird die Folie einschließlich der hilfsweise gewachsenen Nanodrähte wieder entfernt. Das kann beispielsweise durch ein mechanisches Entfernen wie beispielswiese ein Abziehen der Folie erfolgen. Dabei können die hilfsweise gewachsenen Nanodrähte an der Grenzfläche zwischen der Folie und der Oberfläche abbrechen. Das ist insbesondere der Fall, wenn die hilfsweise gewachsenen Nanodrähte besonders dünn ausgeführt sind. Die hilfsweise gewachsenen Nanodrähte können insbesondere dünner sein als die Nanodrähte, die nach Abschluss des Verfahrens auf der Oberfläche verbleiben und auf deren Wachstum das Verfahren gerichtet ist. Durch Wachsen der hilfsweise gewachsenen Nanodrähte und das anschließende Entfernen der Folie einschließlich der hilfsweise gewachsenen Nanodrähte kann eine besonders ebene Fläche erhalten werden, auf der anschließend erneut mittelbar oder unmittelbar Nanodrähte gewachsen werden können. Auf diese Weise können Strukturen bereitgestellt werden, die hier als Bumps bezeichnet werden sollen. Damit ist gemeint, dass insbesondere die Auslassungen in der Grundstrukturierungsschicht mit dem Material der Nanodrähte derart gefüllt werden, dass die Bumps zusammen mit der obersten Schicht des Schichtaufbaus (also insbesondere mit der Strukturierungsschicht) eine durchgehende und ebene Fläche bilden. Vorteilhafter Weise können die Bumps somit zum Höhenausgleich eingesetzt werden und als Kontaktvermittler Verwendung finden. Auf diese Bumps können die Nanodrähte gewachsen werden, die nach Abschluss des Verfahrens auf der Oberfläche verbleiben und auf deren Wachstum das Verfahren gerichtet ist. Auf diese besonders ebene Fläche können diese Nanodrähte besonders gleichmäßig hoch wachsen. Die für diese Ausführungsform beschriebenen zusätzlichen Schritte können zusammenfassend als ein Glätten der Oberfläche beschrieben werden bzw. zum Erzeugen der Bumps verwendet werden.

In einer weiteren bevorzugten Ausführungsform des Verfahrens wird nach Abschluss des Wachstums der Vielzahl der Nanodrähte eine Oxidschicht auf den Nanodrähten zumindest teilweise entfernt.

Die nach dem beschriebenen Verfahren bereitgestellten Nanodrähte können insbesondere dazu verwendet werden, elektrische Leiter elektrisch und/oder mechanisch miteinander zu verbinden. Insbesondere können zwei Flächen miteinander verbunden werden. Dazu wird bevorzugt auf einer oder auf beiden der zu verbindenden Flächen jeweils eine Vielzahl von Nanodrähten bereitgestellt. Anschließend können die so erhaltenen Nanodrähte durch Aneinanderdrücken der Flächen miteinander in Kontakt gebracht werden. Dabei können die Nanodrähte eine elektrisch, mechanisch und/oder thermisch besonders stabile Verbindung zwischen den zu verbindenden Flächen ausbilden. Auf den Nanodrähten kann sich allerdings eine (natürliche) Oxidschicht bilden, die die mechanischen, elektrischen und/oder thermischen Eigenschaften der Verbindung verschlechtern kann. Durch Entfernen dieser Oxidschicht vor Ausbilden der Verbindung kann folglich die Qualität der Verbindung hinsichtlich der genannten Aspekte verbessert werden. Auch kann ein bei der Ausbildung der Verbindung notwendiger Druck durch Entfernen der Oxidschicht reduziert werden oder es kann ganz auf das Ausüben eines Drucks verzichtet werden. Das Entfernen der Oxidschicht findet vorzugsweise durch Anwendung eines Flußmittels (wie z.B. einer Säure, insbesondere einer reduzierenden Säure, wie Salzsäure (HCl) oder Ameisensäure (CH₂O₂)) oder durch ein Plasma (z. B. ein Argon-Plasma) statt. Vorzugsweise enthält die verwendete Säure keine SauerstoffAtome (die durch chemische Reaktionen freigesetzt werden könnten, was zur erneuten Ausbildung der Oxidschicht beitragen könnte). Besonders bevorzugt trägt das Flußmittel auch zu der Ausbildung der Verbindung bei. Dies kann beispielsweise bei Akrylaten der Fall sein.

Die mit dem beschriebenen Verfahren erhaltenen Nanodrähte können insbesondere dazu verwendet werden, Kontaktflächen miteinander zu verbinden. Dazu wird bevorzugt auf einer oder auf allen an der Verbindung beteiligten Kontaktflächen jeweils eine Vielzahl von Nanodrähten nach dem beschriebenen Verfahren bereitgestellt. Durch Zueinanderführen der Kontaktflächen können die Nanodrähte miteinander in Kontakt gebracht werden, wobei die Nanodrähte miteinander verhaken und so eine Verbindung ausbilden. Das Entfernen der Oxidschicht erfolgt bevorzugt nach dem Zueinanderführen der Kontaktflächen. Alternativ oder zusätzlich erfolgt das Entfernen der Oxidschicht vor dem und/oder während des Zueinanderführen(s) der Kontaktflächen.

Vor der Verwendung oder bei der Verwendung der hergestellten Nanodrähte können diese auch einer weiteren Behandlung unterzogen werden. So wird vorteilhafterweise durch eine Verwendung eines reduzierenden Mediums eine potentiell vorhandene Oxidschicht auf den Nanodrähten entfernt. Einer Entfernung einer Oxidschicht kann mittels Ameisensäure und/oder mittels Ultraschall erfolgen. Ein reduzierendes Medium kann auch eine Adhäsion (Verschmelzen der Nanodrähte zu einem im wesentlichen geschlossenen Gefüge) zusätzlich unterstützen, was zu einer Erhöhung der Festigkeit der Verbindung führen kann. Bei dem Medium kann es sich um ein flüssiges oder gasförmiges Medien handeln, welches die verbundenen Nanodrähte durchströmt und so die Oxidschicht entfernt und das Verschmelzen der Nanodrähte unterstützt. Vorzugsweise wird hierzu beispielsweise Ameisensäure verwendet.

Das Entfernen der Oxidschicht erfolgt bevorzugt im Vakuum (insbesondere in einer Vakuumkammer) oder unter einer Schutzgasatmosphäre, so dass ein erneutes Bilden einer Oxidschicht durch Luftsauerstoff unterbunden wird. Auch ist es bevorzugt, dass die Nanodrähte nach dem Entfernen der Oxidschicht und insbesondere bis zum Verbinden nicht mit Luft beziehungsweise mit Sauferstoff in Kontakt kommen. Auch das Verbinden der elektrischen Leiter erfolgt bevorzugt im Vakuum oder unter einer Schutzgasatmosphäre.

Weiterhin wird eine Anordnung zum Bereitstellen einer Vielzahl von Nanodrähten vorgestellt, die jedoch nicht in den Schutzumfang der Ansprüche fällt, die zumindest umfasst:
- eine (vorzugsweise elektrisch leitende) Oberfläche, auf die die Nanodrähte gewachsen werden sollen,
- eine auf die Oberfläche aufgelegte Folie, wobei die Folie eine Vielzahl von durchgehenden Poren aufweist, in denen die Nanodrähte gewachsen werden können,
- ein auf die Folie aufgelegtes Mittel zum Bereitstellen eines Elektrolyten, und
- mindestens eine Elektrode zum galvanischen Wachsen der Vielzahl von Nanodrähten aus dem Elektrolyten.

Die weiter oben beschriebenen besonderen Vorteile und Ausgestaltungsmerkmale des Verfahrens sind auf die beschriebene Anordnung anwendbar und übertragbar, und umgekehrt.

Als eine unterste Bezugsebene wird die Oberfläche beispielsweise eines Substrates verwendet. Die Oberfläche kann, wie zum Beispiel bei einem printed circuit board (PCB) oder bei einer äquivalenten Oberfläche mit leitenden Strukturen beispielsweise aus Kupfer, Gold oder Aluminium versehen sein. Insbesondere sofern die Oberfläche nicht hinreichend elektrisch leitend ist, wird bevorzugt eine durchgängige elektrisch leitende Schicht derart auf die Oberfläche aufgebracht, dass die elektrisch leitende Schicht als Elektrode für das beschriebene Verfahren verwendet werden kann. Vorzugsweise wird ein Haftvermittler (insbesondere eine Haftschicht) zwischen der Oberfläche und der elektrisch leitenden Elektrodenschicht vorgesehen. Vorzugsweise wird dabei eine durchgängige elektrisch leitende Haftschicht auf der Oberfläche erhalten.

Es kann ausreichend sein, lediglich eine Elektrode (beispielsweise eine Gegenelektrode) vorzusehen. Als zweite für das galvanische Wachstum der Nanodrähte benötigte Elektrode wird dann die Oberfläche verwendet, auf die die Nanodrähte gewachsen werden sollen. Ist auf die Oberfläche eine Metallisierung aufgebracht (beispielsweise weil die Oberfläche nicht, nicht durchgängig oder nicht hinreichend, elektrisch leitend ist), kann die Metallisierung (Elektrodenschicht) als die zweite Elektrode dienen. Alternativ ist es bevorzugt, dass zwei Elektroden vorgesehen sind, zwischen denen die zum Wachstum der Nanodrähte benötigte Spannung angelegt werden kann.

In einem Beispiel, das nicht in den Schutzumfang der Ansprüche fällt, umfasst die Anordnung weiterhin eine zwischen der Oberfläche bzw. Elektrodenschicht und der Folie angeordnete Strukturierungsschicht, wobei die Strukturierungsschicht mindestens eine Auslassung aufweist an einer Stelle der Oberfläche, an der die Nanodrähte auf die Oberfläche gewachsen werden sollen.

In einem Beispiel, das nicht in den Schutzumfang der Ansprüche fällt, umfasst die Anordnung weiterhin eine Vorrichtung zum Bereitstellen der Strukturierungsschicht auf der Oberfläche, auf die die Nanodrähte gewachsen werden sollen.

Bei der Vorrichtung zum Bereitstellen der Strukturierungsschicht handelt es sich vorzugsweise um eine Laminiervorrichtung, eine Vakuumbeschichtungsanlage, eine Lackschleuder oder eine Sprüheinrichtung. Mit dieser kann vorzugsweise eine Lackschicht als die Strukturierungsschicht auf die Oberfläche aufgebracht werden.

In einem Beispiel, das nicht in den Schutzumfang der Ansprüche fällt, umfasst die Anordnung weiterhin eine Referenzelektrode.

Die Referenzelektrode ist vorzugsweise innerhalb des Mittels zum Bereitstellen des Elektrolyten angeordnet. Vorzugsweise ist die Referenzelektrode derart über eine Messelektronik mit mindestens einer der für die Elektrolyse vorgesehenen Elektroden verbunden, dass eine elektrochemische Potentialdifferenz zwischen der Referenzelektrode und der für die Elektrolyse vorgesehenen Elektrode einstellbar ist. Dies kann insbesondere unter Verwendung eines Messgeräts, insbesondere eines solchen für eine elektrische Spannung, erfolgen. Der erhaltene Wert ist ein Maß für die elektrochemische Aktivität an der Elektrodenoberfläche. Über den erhaltenen Wert kann insbesondere erkannt werden, wie viel Elektrolyt dem Mittel zum Bereitstellen des Elektrolyten zugeführt werden muss.

Gemäß einem weiteren Aspekt der Erfindung wird eine Vorrichtung zum Bereitstellen einer Vielzahl von Nanodrähten auf einer Oberfläche eines Substrats vorgestellt, die die Merkmale des unabhängigen Anspruchs 1 umfasst.

Die weiter oben beschriebenen besonderen Vorteile und Ausgestaltungsmerkmale des Verfahrens und der Anordnung sind auf die beschriebene Vorrichtung anwendbar und übertragbar, und umgekehrt.

Die beschriebene Vorrichtung ist insbesondere dazu bestimmt und eingerichtet, das beschriebene Verfahren zum Bereitstellen der Vielzahl der Nanodrähte besonders effizient und wiederholbar durchzuführen. Mit der beschriebenen Vorrichtung kann insbesondere auf besonders benutzerfreundliche Weise die beschriebene Anordnung zum Bereitstellen der Vielzahl der Nanodrähte realisiert werden. Die Vorrichtung kann dazu bestimmt und eingerichtet sein, die Nanodrähte durch einen vollautomatisch oder halbautomatisch ablaufenden Prozess und/oder durch einen manuell durchgeführten Prozess bereitzustellen.

Das Substratmodul und das Galvanikmodul können bevorzugt jeweils nach Art einer Schublade in das Gehäuse eingeschoben und aus diesem wieder herausgezogen werden.

Für das Substratmodul weist das Gehäuse die erste Einschubeinheit auf. Die erste Einschubeinheit umfasst bevorzugt Schienen an dem Gehäuse, die in entsprechende Ausnehmungen des Substratmoduls (insbesondere nach Art einer Schublade) eingreifen können. Die Aufnahme des Substratmoduls für das Substrat ist bevorzugt derart ausgeführt, dass Substrate verschiedener Materialien, Formen, Größen und Dicken in das Substratmodul eingelegt werden können. Bevorzugt wird das Substrat in der Aufnahme des Substratmoduls derart fixiert, dass das Substrat während des Wachstums der Nanodrähte ortsfest gehalten wird. Dazu kann das Substrat beispielsweise auch in das Substratmodul eingeklebt werden oder es kann über Klemmen an dem Substratmodul gehalten werden.

Für das Galvanikmodul umfasst das Gehäuse die zweite Einschubeinheit. Die zweite Einschubeinheit umfasst bevorzugt Schienen an dem Gehäuse, die in entsprechende Ausnehmungen des Galvanikmoduls (insbesondere nach Art einer Schublade) eingreifen können. Die Aufnahme für das Mittel zum Bereitstellen des Elektrolyten ist bevorzugt derart ausgeführt, dass das Mittel zum Bereitstellen des Elektrolyten insbesondere in Form einer Galvanikkapsel in das Galvanikmodul eingelegt werden kann. Dabei ist bevorzugt, dass die Galvanikkapsel in oder an dem Galvanikmodul befestigt werden kann. Das kann beispielsweise über Klemmen erfolgen.

Bevorzugt weist die Vorrichtung mindestens eine Elektrode auf, die an dem Mittel zum Bereitstellen des Elektrolyten anliegt. Die mindestens eine Elektrode kann insbesondere zum Wachstum der Nanodrähte verwendet werden. Bevorzugt weist die Vorrichtung genau eine derartige Elektrode auf. Die zweite für das Wachstum der Nanodrähte benötige Elektrode wird bevorzugt von der Oberfläche des Substrats gebildet. Dazu wird bevorzugt ein elektrisch leitendes Substrat verwendet. Alternativ ist bevorzugt, dass ein Substrat verwendet wird, das eine elektrisch leitende Oberfläche aufweist, die beispielsweise durch Metallisierung als Schicht erhalten wurde.

Weiterhin umfasst das Gehäuse bevorzugt eine Steuerung zum Durchführen und Kontrollieren des Wachstums der Nanodrähte. Die Steuerung ist bevorzugt über elektrische Leitungen an die Elektroden und/oder an das Substrat oder jedenfalls an dessen Oberfläche angebunden. Außerdem ist die Steuerung bevorzugt an eine Bedieneinheit (umfassend beispielsweise Knöpfe) angebunden, über die ein Benutzer Eingaben in die Steuerung vornehmen kann und/oder über die ein Benutzer Informationen angezeigt bekommen kann. Auch kann die Bedieneinheit und/oder die Steuerung eine Schnittstelle umfassen, um beispielsweise einen Computer an die Steuerung anzuschließen und über den Computer Informationen in die Steuerung zu laden, aus dieser zu entnehmen oder um die Vorrichtung und damit das Wachstum der Nanodrähte über den Computer zu steuern.

Weiterhin weist die Vorrichtung vorzugsweise mindestens einen Versorgungsanschluss auf, über den die Vorrichtung mit elektrischer Energie versorgt werden kann, die insbesondere für das Wachstum der Nanodrähte benötigt wird.

In einer bevorzugten Ausführungsform der Vorrichtung sind das Galvanikmodul und/oder das Substratmodul relativ zueinander in einer vertikalen Richtung verschieblich ausgebildet.

Das Galvanikmodul und das Substratmodul werden bevorzugt aneinandergepresst. Damit kann das weiter vorne beschriebene Aneinanderpressen des Mittels zum Bereitstellen des Elektrolyten und des Substrats erreicht werden. Das kann in dieser Ausführungsform insbesondere dadurch ermöglicht werden, dass das Galvanikmodul und das Substratmodul relativ zueinander in der vertikalen Richtung verschoben werden können.

In einer weiteren bevorzugten Ausführungsform der Vorrichtung ist die Aufnahme für das Mittel zum Bereitstellen des Elektrolyten relativ zum Galvanikmodul in einer vertikalen Richtung verschieblich.

In dieser Ausführungsform kann das Mittel zum Bereitstellen des Elektrolyten unabhängig von dem Galvanikmodul verschoben werden. Damit kann das Mittel zum Bereitstellen des Elektrolyten an das Substrat gepresst werden, ohne dass das Galvanikmodul verschoben wird. Es ist aber auch bevorzugt, dass das Mittel zum Bereitstellen des Elektrolyten innerhalb des Galvanikmoduls verschoben wird und dass zusätzlich auch das Galvanikmodul verschoben wird.

In einer weiteren bevorzugten Ausführungsform der Vorrichtung ist mindestens eine Anpresseinrichtung vorgesehen, mittels derer das Mittel zum Bereitstellen des Elektrolyten und das Substrat gegeneinander gepresst werden können.

Die Anpresseinrichtung kann beispielsweise mechanisch, elektrisch und/oder pneumatisch ausgeführt sein. Insbesondere umfasst die Anpresseinrichtung bevorzugt mindestens eine Feder. Bevorzugt ist die Anpresseinrichtung zwischen dem Galvanikmodul (sofern dieses in das Gehäuse eingeschoben ist) und einer Innenwand des Gehäuses oder einer Halterung, die mit dem Gehäuse fest verbunden ist, angeordnet. Sind das Galvanikmodul und das Substratmodul in das Gehäuse eingeschoben, so übt die Anpresseinrichtung bevorzugt eine Kraft auf das Mittel zum Bereitstellen des Elektrolyten aus, die das Mittel zum Bereitstellen des Elektrolyten an das Substrat drückt. Alternativ kann die Kraft auch auf das Substrat ausgeübt werden, so dass das Substrat an das Mittel zum Bereitstellen des Elektrolyten gepresst wird. Ein derartiges Aneinanderdrücken des Mittels zum Bereitstellen des Elektrolyten und des Substrats kann insbesondere dadurch ermöglicht werden, dass die als Schienen ausgeführten Einschubeinheiten in Ausnehmungen des Substratmoduls beziehungsweise des Galvanikmoduls eingreifen, wobei die Ausnehmungen derart groß bemessen sind, dass eine Verschiebung des Galvanikmoduls und/oder des Substratmoduls in die vertikale Richtung möglich ist. Sind die Ausnehmungen in dem Galvanikmodul und/oder in dem Substratmodul größer als die jeweiligen als Schienen ausgeführten Einschubeinheiten, kann sich für das Galvanikmodul beziehungsweise für das Substratmodul eine Bewegungsfreiheit in der vertikalen Richtung ergeben. Bevorzugt ist die Bewegungsfreiheit derart bemessen, dass das Galvanikmodul und das Substratmodul durch die Anpresseinrichtung hinreichend fest aneinander gedrückt werden können, so dass der aus dem Mittel zum Bereitstellen des Elektrolyten austretende Elektrolyt nur mit dem Substrat in Kontakt gelangen kann und nicht quer zu dem Galvanikmodul und dem Substratmodul austreten kann. Es ist insbesondere bevorzugt, dass zwischen dem Galvanikmodul und dem Substratmodul eine Dichtung vorgesehen ist, durch die ein derartiges Austreten des Elektrolyten quer zu dem Galvanikmodul und dem Substratmodul weiter erschwert wird. Die Dichtung ist bevorzugt um die Aufnahme für das Mittel zum Bereitstellen des Elektrolyten umlaufend ausgeführt. Beispielsweise kann es sich bei der Dichtung um eine Gummidichtung handeln.

Die mindestens eine Elektrode kann beispielsweise als ein Stempel ausgeführt sein, über den die Anpresseinrichtung das Mittel zum Bereitstellen des Elektrolyten an die Oberfläche des Substrats anpressen kann. Alternativ kann die mindestens eine Elektrode auch folienartig ausgeführt sein. In dem Fall weist die Anpresseinrichtung bevorzugt eine Platte auf, über welche ein Druck auf das Mittel zum Bereitstellen des Elektrolyten ausgeübt werden kann.

In einer weiteren bevorzugten Ausführungsform der Vorrichtung ist die Anpresseinrichtung signaltechnisch mit einer Steuerung verbunden, derart, dass eine Anpresskraft und/oder ein zeitlicher Verlauf der Anpresskraft gesteuert werden können.

Die Anpresskraft kann, wie weiter vorne beschrieben, einen Einfluss auf das Wachstum der Nanodrähte haben. Insbesondere kann durch Reduzierung der Anpresskraft ein Verstopfen der Poren verhindert werden.

In einer weiteren bevorzugten Ausführungsform der Vorrichtung ist das Mittel zum Bereitstellen des Elektrolyten lösbar mit der Aufnahme verbunden.

Das Mittel zum Bereitstellen des Elektrolyten kann bevorzugt in das Galvanikmodul eingelegt und (insbesondere nach Gebrauch) aus diesem wieder entnommen werden.

In einer weiteren bevorzugten Ausführungsform der Vorrichtung ist das Mittel zum Bereitstellen des Elektrolyten auswechselbar.

Das Material der gewachsenen Nanodrähte hängt insbesondere von der Wahl des Elektrolyten ab. Insbesondere deshalb ist es bevorzugt, dass für verschiedene Anforderungen an das Wachstum der Nanodrähte verschiedene Mittel zum Bereitstellen des Elektrolyten bereitgestellt werden. In Abhängigkeit der gewünschten Eigenschaften der zu wachsenden Nanodrähte (insbesondere deren Material) kann dabei ein entsprechendes Mittel zum Bereitstellen des Elektrolyten gewählt und in das Galvanikmodul eingelegt werden.

In einer weiteren bevorzugten Ausführungsform der Vorrichtung ist eine Folie mit einer Vielzahl von durchgehenden Poren, in denen die Nanodrähte gewachsen werden können, auf dem Substrat vorgesehen.

Insbesondere in dieser Ausführungsform liegt die Vorrichtung in einem solchen Zustand vor, in welchem das Wachstum der Nanodrähte gemäß dem weiter oben beschriebenen Verfahren und gemäß der weiter oben beschriebenen Anordnung durchgeführt werden kann. Dazu sind die Oberfläche des Substrats, die Folie, das Mittel zum Bereitstellen des Elektrolyten und die mindestens eine Elektrode innerhalb der Vorrichtung vorzugsweise gemäß der weiter vorne beschriebenen Anordnung angeordnet. Dabei ist insbesondere bevorzugt, dass über den Elektrolyten aus dem Mittel zum Bereitstellen des Elektrolyten eine galvanische Verbindung zwischen der mindestens einen Elektrode, die für das Wachstum der Nanodrähte verwendet wird, und dem Substrat mit einer bevorzugt elektrisch leitenden Oberfläche ausgebildet wird. Die weiterhin für die Anordnung beschriebene Strukturierungsschicht, die Haftschicht und gegebenenfalls weitere vorgesehene Schichten auf der Oberfläche werden bevorzugt auf die Oberfläche des Substrats aufgebracht, bevor dieses in das Substratmodul eingelegt wird oder jedenfalls bevor das Substratmodul in das Gehäuse eingeschoben wird.

In einer weiteren bevorzugten Ausführungsform der Vorrichtung ist ein Magazin für die Folie vorgesehen.

Das Magazin für die Folie umfasst bevorzugt eine Rolle, auf der die Folie vorgehalten wird. Die Folie kann von der Rolle abgerollt und auf das Substrat aufgelegt werden. Das Anlegen der Folie an das Substrat kann erfolgen bevor oder nachdem das Substrat in die Aufnahme des Substratmoduls eingelegt ist. Das Anlegen der Folie an das Substrat kann weiterhin erfolgen bevor oder nachdem das Substratmodul in das Gehäuse eingeschoben ist. Nach Abschluss des Wachstums der Nanodrähte kann das Substratmodul mit dem Substrat aus dem Gehäuse entnommen werden und das Substrat kann aus der Aufnahme des Substratmoduls entnommen werden. Dabei verbleibt die Folie bevorzugt auf dem Substrat. Anschließend durchgeführte Prozessschritte (wie beispielsweise ein Entfernen der Folie) erfolgen bevorzugt außerhalb des Gehäuses. Um das Substrat aus dem Gehäuse entnehmen zu können, wird der auf dem Substrat befindliche Teil der Folie bevorzugt von der übrigen Folie auf der Rolle des Magazins getrennt. Das kann insbesondere manuell (beispielsweise mit einer Schere oder einem Messer) erfolgen. Auch kann das Magazin eine Schnittvorrichtung umfassen, mittels derer die Folie von der Rolle abgeschnitten werden kann. In dieser Ausführungsform ist es bevorzugt, dass das Mittel zum Bereitstellen des Elektrolyten mit einer durchlässigen Zwischenfolie versehen ist, die ein Austreten des Elektrolyten ermöglicht, das Mittel zum Bereitstellen des Elektrolyten (z.B. einen Schwamm) aber zurückhält. So kann das Mittel zum Bereitstellen des Elektrolyten insbesondere innerhalb des Galvanikmoduls gehalten werden. Weiterhin ist die durchlässige Zwischenfolie vor Gebrauch mit einer für den Elektrolyten undurchlässigen Schutzfolie versehen.

In einer weiteren bevorzugten Ausführungsform der Vorrichtung ist die Folie an der dem Substrat zugewandten Fläche des Galvanikmoduls vorgesehen.

Die Folie ist insbesondere zwischen der Oberfläche des Substrats und dem Mittel zum Bereitstellen des Elektrolyten vorgesehen. Das kann, wie für die vorherige Ausführungsform beschrieben, zum einen durch Auflegen der Folie auf die Oberfläche des Substrats erfolgen. Zum anderen kann dies, wie es in der hier vorliegenden Ausführungsform der Fall ist, dadurch erfolgen, dass die Folie an der dem Substrat zugewandten Fläche des Galvanikmoduls vorgesehen ist. Dabei ist es bevorzugt, dass das Mittel zum Bereitstellen des Elektrolyten zusammen mit der Folie bereitgestellt wird. Das Mittel zum Bereitstellen des Elektrolyten kann beispielsweise in einer Umhüllung bereitgestellt werden, die ein Austreten des Elektrolyten verhindern kann. Die Folie ist bevorzugt ein Teil einer solchen Umhüllung, wobei das Elektrolyt nur über die Folie aus der Umhüllung austreten kann. Die derart bereitgestellten Folie und Mittel zum Bereitstellen des Elektrolyten können insbesondere gemeinsam in das Galvanikmodul eingelegt und aus diesem entnommen werden.

In einer weiteren bevorzugten Ausführungsform der Vorrichtung umfasst das Mittel zum Bereitstellen des Elektrolyten einen Schwamm.

Ein Schwamm kann den Elektrolyten insbesondere aufnehmen, speichern, in Abhängigkeit eines Drucks abgeben und/oder die Folie auf der Oberfläche des Substrats fixieren.

In einer weiteren bevorzugten Ausführungsform der Vorrichtung wird der Elektrolyt in einem Behälter bereitgestellt.

Bevorzugt ist der Behälter von dem Mittel zum Bereitstellen des Elektrolyten umgeben. Ist das Mittel zum Bereitstellen des Elektrolyten beispielsweise als Schwamm ausgeführt, so ist bevorzugt, dass der Behälter innerhalb des Schwamms angeordnet ist. Alternativ ist es bevorzugt, dass der Behälter neben dem Mittel zum Bereitstellen des Elektrolyten in dem Galvanikmodul vorgesehen ist. Bevorzugt ist der Behälter (insbesondere vor Gebrauch) mit dem Elektrolyten gefüllt. Der Behälter ist bevorzugt derart ausgeführt, dass der Behälter bei Druckausübung auf den Behälter und/oder auf das Mittel zum Bereitstellen des Elektrolyten den Elektrolyten freigibt, so dass der Elektrolyt in das Mittel zum Bereitstellen des Elektrolyten eingeleitet wird. Das kann beispielsweise dadurch erreicht werden, dass der Behälter mit einem Material wie beispielsweise einem Kunststoff gebildet ist, so dass der Behälter bei Druckausübung auf den Behälter und/oder auf das Mittel zum Bereitstellen des Elektrolyten aufplatzt. Es ist bevorzugt, dass das Mittel zum Bereitstellen des Elektrolyten und der Behälter zum einmaligen Gebrauch bestimmt und eingerichtet sind.

In einer weiteren bevorzugten Ausführungsform der Vorrichtung weist der Behälter einen porenartig ausgebildeten Boden auf.

In dieser Ausführungsform kann der Behälter insbesondere unter Druckeinwirkung den Elektrolyten freigeben (so dass der Elektrolyt insbesondere in das Mittel zum Bereitstellen des Elektrolyten eingeleitet wird), ohne dass der Behälter aufplatzt. Damit kann der Behälter insbesondere wiederverwendet werden.

In einer weiteren bevorzugten Ausführungsform der Vorrichtung bilden das Mittel zum Bereitstellen des Elektrolyten und der Behälter eine Baueinheit.

Das Mittel zum Bereitstellen des Elektrolyten und der Behälter sind bevorzugt von einer gemeinsamen Umhüllung umgeben, die vorzugsweise mit einem für den Elektrolyten undurchlässigen Material gebildet ist. Wird der Elektrolyt aus dem Behälter freigegeben, kann der Elektrolyt insbesondere innerhalb der gemeinsamen Umhüllung in das Mittel zum Bereitstellen des Elektrolyten gelangen, ohne dass Elektrolyt verloren geht oder in Bereiche der Vorrichtung gelangt, die dazu nicht bestimmt sind. Insbesondere ist es bevorzugt, dass die Folie Teil dieser Umhüllung ist (so dass die Folie einen Bereich der Umhüllung überspannt, in dem kein Material der Umhüllung vorgesehen ist) und dass der Elektrolyt nur über die Folie aus der Umhüllung austreten kann. Ist die Folie nicht in der Umhüllung vorgesehen, weißt die Umhüllung bevorzugt eine Öffnung auf, über die der Elektrolyt abgegeben werden kann. Die Öffnung kann vor Gebrauch beispielsweise mit einer Schutzfolie verschlossen sein.

In einer weiteren bevorzugten Ausführungsform der Vorrichtung ist eine Einrichtung vorgesehen, mittels derer der Behälter mit Druck beaufschlagbar ist.

Der Behälter kann insbesondere dadurch mit Druck beaufschlagt werden, dass das Volumen des Behälters durch einen äußeren Einfluss reduziert wird. Der Behälter wird dabei zusammengedrückt. Der Behälter ist dazu vorzugsweise mit einem flexiblen Material ausgebildet. Bevorzugt wird der Druck mit der Anpresseinrichtung, mit der auch die Folie an das Substrat angepresst wird, auf den Behälter ausgeübt.

Alternativ oder zusätzlich kann der Druck im Behälter dadurch erhöht werden, dass ein Gas wie beispielsweise Luft oder Stickstoff in den Behälter unter erhöhtem Druck eingeleitet wird. Dazu ist der Behälter bevorzugt mit einem Material gebildet, dass sich bei einer derartigen Beaufschlagung mit Druck nicht verformt. Auch kann der Behälter zumindest teilweise mit einem flexiblen Material gebildet sein, wobei das Volumen des Behälters durch einen äußeren Einfluss (insbesondere durch die Anpresseinrichtung) derart begrenzt wird, dass sich der Behälter trotz des flexiblen Materials bei Beaufschlagung mit Druck nicht oder nur wenig vergrößert.

In einer weiteren bevorzugten Ausführungsform der Vorrichtung ist die Oberfläche des Substrats elektrisch leitend, wobei das Substrat elektrisch leitend mit einer Steuerung der Vorrichtung verbunden ist.

Bevorzugt weist das Substratmodul mindestens einen Substratkontakt auf, über den ein elektrischer Kontakt zwischen einer innerhalb des Substratmoduls verlaufenden Leitung und dem Substrat oder jedenfalls der Oberfläche des Substrats hergestellt wird, sobald das Substrat in die Aufnahme des Substratmoduls eingelegt ist. Das Substratmodul weist weiterhin bevorzugt mindestens einen Substratmodulkontakt auf, über den ein elektrischer Kontakt zwischen der Leitung innerhalb des Substratmoduls und einer innerhalb des Gehäuses verlaufenden Leitung hergestellt wird, sobald das Substratmodul in das Gehäuse eingeschoben ist. Die innerhalb des Gehäuses verlaufende Leitung führt bevorzugt von dem Substratmodulkontakt zu der Steuerung. Ist das Substrat in die Aufnahme des Substratmoduls eingelegt und ist das Substratmodul in das Gehäuse eingeschoben, ist das Substrat oder jedenfalls dessen Oberfläche bevorzugt elektrisch leitend über den Substratkontakt, die innerhalb des Substratmoduls verlaufende Leitung, den Substratmodulkontakt und die innerhalb des Gehäuses verlaufende Leitung mit der Steuerung verbunden. Außerdem ist bevorzugt auch die mindestens eine Elektrode mit der Steuerung verbunden. Damit kann das Wachstum der Nanodrähte über die Steuerung durchgeführt und kontrolliert werden.

Alternativ kann das Substrat oder jedenfalls dessen Oberfläche durch ein Kabel unmittelbar elektrisch leitend mit der Steuerung verbunden werden. Das Kabel kann beispielsweise manuell über eine Steckverbindung, eine Klemmverbindung oder einen Federkontakt an das Substrat angebunden werden. Auch ist es möglich, dass das Substrat oder jedenfalls dessen Oberfläche durch ein Kabel unmittelbar elektrisch leitend mit der innerhalb des Substratmoduls verlaufenden Leitung verbunden werden.

Gemäß einem Beispiel, das nicht in den Schutzumfang der Ansprüche fällt, wird eine Galvanikkapsel zum Bereitstellen einer Vielzahl von Nanodrähten auf einer Oberfläche eines Substrats vorgestellt, die zumindest umfasst:
- einen Behälter enthaltend einen Elektrolyten,
- eine Folie mit einer Vielzahl von durchgehenden Poren, in denen die Nanodrähte gewachsen werden können, und
- ein Mittel zum Bereitstellen des Elektrolyten zu der Folie.

Die weiter oben beschriebenen besonderen Vorteile und Ausgestaltungsmerkmale des Verfahrens, der Anordnung und der Vorrichtung sind auf die beschriebene Galvanikkapsel anwendbar und übertragbar, und umgekehrt. Insbesondere ist es bevorzugt, dass die beschriebene Galvanikkapsel zum Wachstum von Nanodrähten nach dem beschriebenen Verfahren und unter Verwendung der beschriebenen Anordnung verwendet wird. Besonders bevorzugt ist es, dass die Galvanikkapsel mit der beschriebenen Vorrichtung verwendet wird.

Die Galvanikkapsel ist dazu bestimmt und eingerichtet, in das Galvanikmodul der beschriebenen Vorrichtung eingelegt zu werden. Die Galvanikkapsel umfasst bevorzugt zumindest eine Umhüllung für das Mittel zum Bereitstellen des Elektrolyten. Die Umhüllung kann beispielsweise mit Kunststoff gebildet sein. Insbesondere ist es bevorzugt, dass das Material der Galvanikkapsel derart gewählt ist, dass durch Druckausübung auf die Galvanikkapsel der Elektrolyt von dem Mittel zum Bereitstellen des Elektrolyten abgegeben wird und/oder dass der Elektrolyt aus dem Behälter in das Mittel zum Bereitstellen des Elektrolyten eingeleitet wird (insbesondere indem der Behälter aufplatzt).

Die Umhüllung der Galvanikkapsel kann weiterhin zumindest teilweise mit einem elektrisch leitfähig beschichteten Kunststoff gebildet sein, so dass die Umhüllung der Kapsel als die mindestens eine Elektrode zum Wachstum der Nanodrähte verwendet werden kann. Weiterhin ist die Folie mit der Vielzahl der durchgehenden Poren bevorzugt als ein Teil der Umhüllung ausgeführt, so dass der Elektrolyt aus dem Mittel zum Bereitstellen des Elektrolyten nur über die Folie und damit nur an einer Seite der Galvanikkapsel abgegeben werden kann. Für Transport und Lagerung der Galvanikkapsel ist die Folie bevorzugt mit einer Schutzfolie geschützt, wobei die Schutzfolie bevorzugt für den Elektrolyten undurchlässig ist. Damit kann der Elektrolyt aus der Galvanikkapsel nicht freigegeben werden, solange die Schutzfolie aufgebracht ist. Vor Benutzung der Galvanikkapsel wird die Schutzfolie bevorzugt entfernt. Die Galvanikkapsel ist bevorzugt für den einmaligen Gebrauch bestimmt und eingerichtet. Alternativ kann die Galvanikkapsel auch mehrfach verwendbar sein. Dazu kann beispielsweise ein Schwamm (als das Mittel zum Bereitstellen des Elektrolyten) in der Galvanikkapsel vorgesehen sein, der erneut mit dem Elektrolyten befüllt werden kann.

Mit der beschriebenen Vorrichtung können Nanodrähte mit einstellbarem Durchmesser, einstellbarer Länge und aus auswählbarem Material gewachsen werden. Die Einstellung von Durchmesser und Länge erfolgt bevorzugt durch Einstellung von Wachstumsbedingungen wie Strom und Spannung, welche bevorzugt über die Steuerung einstellbar sind. Die Wahl des Materials erfolgt bevorzugt über die Wahl des Elektrolyten. Insbesondere deshalb ist es bevorzugt, dass für verschiedene Anforderungen an das Wachstum der Nanodrähte jeweils verschiedene Galvanikkapseln bereitgestellt werden. Insbesondere können für das Wachstum von Nanodrähten verschiedener Materialien verschiedene Galvanikkapseln bereitgestellt werden, die jeweils mit entsprechenden Elektrolyten befüllt sind. Die Vorrichtung weist bevorzugt ein Identifizierungsmittel auf, über welches erkannt werden kann, welcher Typ von Galvanikkapsel in das Galvanikmodul eingelegt ist (und ob überhaupt eine Galvanikkapsel eingelegt ist). Beispielsweise kann die Galvanikkapsel einen Strichcode aufweisen, der über einen als einen Strichcodeleser ausgeführtes Identifizierungsmittel ausgelesen werden kann. Über das Identifizierungsmittel, das bevorzugt an die Steuerung angebunden ist, wird der Steuerung bevorzugt die Information zur Verfügung gestellt, welche Galvanikkapsel eingelegt ist (und ob überhaupt eine Galvanikkapsel eingelegt ist). Beispielsweise kann über das Identifizierungsmittel erkannt werden, welcher Elektrolyt in der Galvanikkapsel vorliegt. Entsprechend kann in der Steuerung beispielsweise ein Wachstumsprogramm geladen werden, das für den entsprechenden Elektrolyten individuell angepasste Wachstumsbedingungen wie beispielsweise Strom, Spannung und Wachstumszeit umfasst.

In einem Beispiel der nicht beanspruchten Galvanikkapsel umfasst das Mittel zum Bereitstellen des Elektrolyten einen Schwamm.

Ein Schwamm kann den Elektrolyten insbesondere aufnehmen, speichern, in Abhängigkeit eines Drucks abgeben und/oder die Folie auf der Oberfläche des Substrats fixieren.

In einem weiteren Beispiel der nicht beanspruchten Galvanikkapsel weist der Behälter einen porenartig ausgebildeten Boden auf.

In diesem Beispiel kann der Behälter insbesondere unter Druckeinwirkung den Elektrolyten freigeben (so dass der Elektrolyt insbesondere in das Mittel zum Bereitstellen des Elektrolyten eingeleitet wird), ohne dass der Behälter aufplatzt. Damit kann der Behälter insbesondere wiederverwendet werden.

Die vorstehenden Ausführungen gelten insbesondere im Zusammenhang mit der Ausbildung einer Anordnung von Halbleiterchips. Es sind verschiedenste Anordnungen von Halbleiterchips bekannt. In vielen Anwendungen werden Halbleiterchips auf eine Platine oder ein Substrat aufgelegt und mit dieser bzw. mit diesem verbunden. Die Verbindung erfolgt üblicherweise über Klebe- oder Lötverfahren. Derartige Verbindungen werden insbesondere unter hohen Temperaturen ausgebildet. Daher ist ein sequentieller Aufbau einer Halbleiteranordnung, etwa aufweisend mehrere aufeinanderliegender Halbleiterchips, nur schwer zu realisieren. Beispielsweise müssen verschiedene Lote verwendet werden, damit eine bereits ausgebildete Verbindung eines ersten Halbleiterchips nicht bei der Ausbildung einer Verbindung mit einem weiteren Halbleiterchip wieder gelöst wird.

Weiterhin können die hohen Temperaturen beim Ausbilden der Verbindung selbst nachteilig sein und z. B. einen Halbleiterchip beschädigen oder die Bildung einer Oxidschicht fördern. Insbesondere um Letzteres zu vermeiden, wird auch oft unter Schutzgas gearbeitet. Ein weiterer Nachteil vieler bekannter Verfahren ist eine nötige Aushärtezeit. Insbesondere innerhalb dieser Zeit kann sich ein Halbleiterchip noch verschieden, so dass eine genaue Positionierung erschwert wird. Dies ist gerade bei Massenproduktion ein erheblicher Nachteil.

Verwendeter Kleber kann bei auch nur leicht zu geringer Dosierung zu einem mangelnden mechanischen Halt führen. Bei einer auch nur leicht zu hohen Dosierung kann sich überschüssiger Kleber in Bereiche ausweiten, wo dies zu nachteiligen Beeinflussungen anderer Bauteile führen kann. Dies gilt insbesondere bei elektrisch leitendem Kleber, der beispielsweise zwei voneinander getrennt zu haltende elektrische Kontakte verbinden kann, wodurch es zu einer erheblichen Fehlfunktion kommen kann.

Weiterhin sind bei vielen bekannten Verfahren die Verbindungen hinsichtlich der elektrischen und/oder thermischen Leitfähigkeit sowie der mechanischen Stabilität nur unzureichend ausgeprägt. Dies wird dadurch versucht zu umgehen, dass große Flächen für die Verbindung verwendet werden. Dies führt oft zu ungewünschten konstruktionstechnischen Problemen.

Mit der Offenbarung wird auch eine Methode ermöglicht, mit der eine Verbindung zwischen mehreren Halbleitern besonders gut hinsichtlich elektrischer und/oder thermischer Leitfähigkeit sowie mechanischer Stabilität ausgebildet werden kann, die jedoch nicht unter den Schutzumfang der Ansprüche fällt.

Eine Anordnung von Halbleiterchips umfasst wenigstens zwei aufeinander aufliegende Halbleiterchips, die über eine Vielzahl von Nanodrähten miteinander verbunden sind.

Unter einem Halbleiterchip wird hier jeder Festkörper aus einem Halbleitermaterial verstanden, auf oder in dem eine Nano- oder Mikrostruktur vorgesehen ist. Bei einer Nano- oder Mikrostruktur kann es sich insbesondere um eine Struktur mit Elementen der Größenordnung von wenigen Nanometern bis mehreren Mikrometern handeln. Diese Struktur kann insbesondere eine integrierte elektronische Schaltung darstellen. Der Begriff des Halbleiterchips ist hier also weit auszulegen und insbesondere nicht hinsichtlich Konstruktionsmerkmalen (nicht weiter als explizit angegeben) einzuschränken. Beispielsweise kann es sich bei dem Halbleiterchip um einen Prozessor für einen Computer, einen Computerchip für eine beschränkte Aufgabe oder einen Computerspeicher handeln.

Die Verbindung über die Nanodrähte hat den Vorteil, besonders gut thermisch leitend zu sein. Das ist durch die große Kontaktoberfläche der Vielzahl der Nanodrähte zu erklären.

Die Anordnung von Halbleiterchips ist vorzugsweise ein Schichtaufbau aus wenigstens zwei Halbleiterchips. Vorzugsweise ist die Verbindung zwischen den Halbleiterchips insbesondere thermisch leitend. Die Verbindung ist vorzugsweise zwischen Grundkörpern der Halbleiterchips ausgebildet, d.h. insbesondere flächig über eine gesamte jeweilige Grundfläche der Halbleiterchips. Insbesondere kann über eine derartige Verbindung eine besonders gute Kühlung durch ein besonders gutes Ableiten von Wärme aus den Halbleiterchips erreicht werden. Die thermische Leitfähigkeit der Verbindung wird insbesondere durch die große Kontaktoberfläche zwischen den an der Verbindung beteiligten Nanodrähten begünstigt.

Durch die Vielzahl der Nanodrähte kann erreicht werden, dass die Verbindung instantan ausgebildet ist. Dadurch kann die Herstellung der beschriebenen Anordnung von Halbleiterchips besonders einfach sein (vgl. dazu insbesondere die Beschreibung des Herstellungsverfahrens weiter unten). Die Herstellung kann insbesondere ohne externe Temperatureinwirkung erfolgen. Damit werden die weiter oben im Zusammenhang mit dem Stand der Technik geschilderten Probleme hinsichtlich hoher Temperaturen umgangen. Insbesondere ermöglicht dies die sequentielle Ausbildung von mehreren Verbindungen, ohne dass beim Ausbilden einer Verbindung eine bereits bestehende wieder gelöst würde (z. B. durch eine zu hohe Temperatur). Ebenso kann die Bildung von Oxiden aufgrund einer zu hohen Temperatur vermieden werden.

Auch erfordert die beschriebene Art der Verbindung keine Aushärtezeit. Überschüssiger Kleber kann keinen nachteiligen Einfluss haben. Aufgrund der großen Kontaktoberfläche zwischen den an der Verbindung beteiligten Nanodrähten kann eine besonders mechanisch stabile Verbindung ausgebildet werden. Dadurch kann die Größe der zu verbindenden Flächen reduziert werden. Aufgrund der Art der Verbindung kann insbesondere auch eine besonders geringe Bauhöhe erreicht werden (weil die Schichtdicke der Verbindung sehr klein gewählt werden kann).

Weiterhin erlaubt die Verbindung der beschriebenen Art eine nahezu unbegrenzte Auswahl an Materialien sowohl der Halbleiterchips als auch der Nanodrähte. Dies liegt daran, dass die Stärke der Verbindung über die Größe der Kontaktoberfläche erreicht wird, und weniger über spezielle Materialeigenschaften. Auch werden aus gleichem Grund nur geringe Anforderungen an die Qualität und Güte der zu verbindenden Kontaktflächen gestellt.

Weiterhin kann die beschriebene Verbindung Vibrationen und ähnliche mechanische Belastungen besonders gut dämpfen. Das liegt daran, dass die Verbindung nicht flächig zwischen starren Halbleiterchips ausgebildet wird, sondern mittelbar über die flexiblen Nanodrähte dazwischen. Damit bildet sich eine Zwischenschicht zwischen den starren Halbleiterchips, die mechanische Belastungen besonders gut ausgleichen kann. Diese Zwischenschicht kann auch als eine eher poröse Struktur betrachtet werden. Die Verbindung ist insbesondere auch besonders langzeitstabil, weil ein Brechen einer starren Verbindung umgangen wird. Insbesondere die Länge der Nanodrähte und eine (optional) bei Ausbildung der Verbindung angewendete Presskraft (d.h. ein aufgebrachter Druck) können die Ausprägung dieser federnden Wirkung der Nanodrähte beeinflussen.

Vorzugsweise sind die Halbleiterchips elektrisch leitend miteinander verbunden. Insbesondere bei einer solchen Anordnung ist es bevorzugt, dass mindestens einer der Halbleiterchips wenigstens teilweise aus einem elektrisch leitenden Grundkörper besteht. Bei einem derartigen Halbleiterchip kann z. B. ein elektrisches Potential an den Grundkörper angelegt werden. Dadurch kann ein Referenzpotential im Halbleiterchip kontrolliert werden. Der Begriff der elektrischen Leitfähigkeit umfasst auch eine elektrische Leitung durch einen Halbleiter. Es ist bevorzugt, dass die Nanodrähte aus einem Metall ausgebildet sind, insbesondere aus Kupfer, Gold, Silber, Platin, Nickel und/oder Zinn.

Die Anordnung von Halbleiterchips weist vorzugsweise ein Substrat auf, auf das die Halbleiterchips aufgelegt sind und mit dem einer der Halbleiterchips über eine Vielzahl von Nanodrähten verbunden ist. Es besteht auch die Möglichkeit, dass mit dem Substrat lediglich ein Halbleiterchip mittels einer Vielzahl von Nanodrähten verbunden wird.

Das Substrat ist vorzugsweise mit einem Halbleitermaterial gebildet. Beispielsweise kann es sich bei dem Substrat um einen Siliziumwafer handeln. Über das Substrat kann die Anordnung von Halbleiterchips in ein übergeordnetes Bauteil integriert werden. Dadurch, dass auch die Verbindung zwischen dem Halbleiterchip und dem Substrat über eine Vielzahl von Nanodrähten erfolgt, ergeben sich auch für diese Verbindung die weiter oben beschriebenen Vorteile.

Zur Ausbildung der Anordnung von Halbleiterchips, aufweisend wenigstens zwei aufeinander aufliegende Halbleiterchips, die über eine Vielzahl von Nanodrähten miteinander verbunden sind, wird einer Vielzahl von Nanodrähten in zumindest einem Bereich einer Kontaktfläche mindestens einer der Halbleiterchips bereitgestellt.

Ein Bereitstellen der Nanodrähte erfolgt vorzugsweise nach dem erfindungsgemäßen Verfahren. Zur Ausbildung der Verbindung kann optional ein Druck auf die Halbleiterchips ausgeübt werden, mittels dem die Halbleiterchips aneinander gedrückt werden. Durch diesen Druck kann die Verbindung über die Nanodrähte besonders stabil ausgeprägt werden. Aufgrund der großen Kontaktoberfläche der Nanodrähte kann die Verbindung auch ohne einen solchen Druck mechanisch stabil ausgebildet werden. Insbesondere sind Festigkeiten der Verbindung im Bereich von MPa [Megapascal] möglich.

Eine Vielzahl von Nanodrähten auf einer jeweiligen Kontaktfläche beider Halbleiterchips bereitgestellt. Hierbei ist es bevorzugt, dass beide an der Verbindung beteiligten Kontaktflächen vollständig mit Nanodrähten bedeckt werden. Alternativ ist es aber auch bevorzugt, nur einen Teil der Kontaktflächen mit Nanodrähten zu bedecken.

In diesem Beispiel, das nicht unter den Schutzumfang der Ansprüche fällt, wird die Verbindung zwischen den beiden Halbleiterchips zwischen den Nanodrähten an den jeweiligen Halbleiterchips ausgebildet. Dadurch kann eine besonders große Kontaktoberfläche erzielt werden, wodurch die Verbindung besonders mechanisch stabil ausgeprägt sein kann. Auch kann insbesondere die thermische und/oder elektrische Leitfähigkeit der Verbindung besonders gut sein. Damit kann eine besonders gute elektrische Verbindung zwischen den beiden Halbleiterchips und/oder eine besonders gute Wärmeleitung zwischen den beiden Halbleiterchips erreicht werden. Letzteres ist insbesondere vorteilhaft im Hinblick auf eine besonders gute Kühlung eines Bauteils aufweisend die Anordnung von Halbleiterchips.

Es ist bevorzugt, aber nicht notwendig, dass eine Strukturierungsschicht auf der Kontaktfläche bereitgestellt wird, die mindestens eine Auslassung aufweist an einer Stelle der Kontaktfläche, an der die Nanodrähte auf die Kontaktfläche gewachsen werden sollen. Mit der Strukturierungsschicht kann also das Wachstum der Nanodrähte lokal begrenzt werden.

Bei der Strukturierungsschicht handelt es sich vorzugsweise um eine Schicht aus einem nicht elektrisch leitenden Material. Die Strukturierungsschicht kann entweder vor Schritt b1) auf die Kontaktfläche aufgebracht werden oder es kann ein Halbleiterchip mit bereits auf der Kontaktfläche befindlicher Strukturierungsschicht bereitgestellt werden.

Die Strukturierungsschicht ist bevorzugt als eine Laminierschicht ausgebildet. Dabei meint Laminierschicht, dass die Strukturierungsschicht durch Erwärmen eines Kunststoffmaterials (insbesondere eines Polymermaterials) auf die Kontaktfläche aufgebracht wird.

Als Alternative zum Laminierungsverfahren kann die Strukturierungsschicht durch einen Fotolack erzeugt werden, der durch einen Lithographie-Prozess (Belichten mit einer Maske) mit der entsprechenden Strukturierung versehen wird und nach dem Entwickeln dann die Auslassungen freigibt auf denen dann die Nanodrähte gewachsen werden.

Durch die Wahl der Anzahl, Position, Größe und Gestalt der mindestens einen Auslassung in der Strukturierungsschicht kann gesteuert werden, in welchen Bereichen der Kontaktfläche die Nanodrähte gewachsen werden sollen. Dies ist insbesondere dadurch möglich, dass die Strukturierungsschicht nicht elektrisch leitend ausgeführt ist, so dass eine galvanische Abscheidung (und damit ein galvanisches Wachstum der Nanodrähte) auf das Strukturierungsschichtmaterial nicht möglich ist. Dabei weist jede Auslassung vorzugsweise eine Ausdehnung auf, die groß ist im Vergleich zu einem mittleren Durchmesser der Nanodrähte und zu einem mittleren Abstand zwischen benachbarten Nanodrähten. Das bedeutet insbesondere, dass innerhalb jeder Auslassung jeweils eine Vielzahl von Nanodrähten gewachsen werden kann.

Die Folie ist vorzugsweise mit einem Kunststoffmaterial, insbesondere mit einem Polymermaterial gebildet. Insbesondere ist es bevorzugt, dass die Folie derart mit der Strukturierungsschicht verbunden wird, dass die Folie nicht verrutscht. Dies könnte die Qualität der gewachsenen Nanodrähte mindern.

Dass die Poren der Folie durchgehend ausgeführt sind, ist vorzugsweise derart realisiert, dass die Poren von einer Oberseite der Folie zu einer Unterseite der Folie durchgehende Kanäle ausbilden. Insbesondere ist es bevorzugt, dass die Poren zylinderförmig ausgeführt sind. Es ist aber auch möglich, dass die Poren als Kanäle mit gekrümmtem Verlauf ausgeführt sind. Eine Pore kann z.B. eine kreisförmige, ovale oder mehreckige Grundfläche aufweisen. Insbesondere kann eine Pore eine hexagonale Grundfläche aufweisen. Vorzugsweise sind die Poren gleichmäßig ausgeführt (d.h. die Poren unterscheiden sich vorzugsweise nicht hinsichtlich der Größe, Form, Anordnung und/oder Abstand zu benachbarten Poren).

Werden die Nanodrähte gewachsen, so werden die Poren vorzugsweise (insbesondere vollständig) mit dem galvanisch abgeschiedenen Material gefüllt. Dadurch erhalten die Nanodrähte die Größe, Form und Anordnung der Poren. Durch Wahl der Folie bzw. der Poren darin können also die Eigenschaften der zu wachsenden Nanodrähte festgelegt bzw. beeinflusst werden. Die Folie kann daher auch als "Template", "Templatefolie" oder "Schablone" bezeichnet werden.

Wird eine Strukturierungsschicht verwendet, ist es bevorzugt, dass die Folie derart auf die Strukturierungsschicht aufgelegt wird, dass die Folie zumindest teilweise die mindestens eine Auslassung in der Strukturierungsschicht überdeckt. Dadurch kann sichergestellt werden, dass zumindest in diesem Bereich der Überlappung ein Wachstum der Nanodrähte stattfinden kann. Weiterhin ist es bevorzugt, dass die Folie zumindest teilweise auch die Strukturierungsschicht in einem Bereich überdeckt, in dem die Strukturierungsschicht keine Auslassung aufweist. Dadurch kann sichergestellt werden, dass die Folie in ihrer Position fixiert ist. Das Mittel zum Bereitstellen des Elektrolyten ist bevorzugt derart ausgeführt, dass es zusätzlich eine Fixierung der Folie bewirken kann. Das kann insbesondere dadurch realisiert sein, dass das Mittel zum Bereitstellen des Elektrolyten flächig ausgeführt ist und zum Anpressen der Folie an die Kontaktfläche bestimmt und eingerichtet ist.

Bei dem Mittel zum Bereitstellen des Elektrolyten kann es sich um jede Vorrichtung handeln, die dazu eingerichtet und bestimmt ist, einen Elektrolyten zumindest an einer Ausgabestelle abzugeben. Vorzugsweise ist die Ausgabestelle flächig ausgeführt, wobei besonders bevorzugt ist, dass der Elektrolyt über eine Ausgabefläche gleichmäßig ausgegeben werden kann. Weiterhin ist es bevorzugt, dass das Mittel zum Bereitstellen des Elektrolyten die Folie vollständig überdeckt. Beispielsweise kann es sich bei dem Mittel zum Bereitstellen des Elektrolyten um einen Schwamm, ein Tuch, einen porösen festen Körper oder aber auch um eine Einspritzeinrichtung mit einer oder mehreren Düsen handeln.

Bevorzugt ist ein Schichtaufbau aus zumindest vier Schichten: Kontaktfläche, Strukturierungsschicht, Folie und Mittel zum Bereitstellen des Elektrolyten (die in der hier genannten Reihenfolge angeordnet sind). Dieser Schichtaufbau kann in jeder beliebiger räumlichen Orientierung verwendet werden. Bevorzugt ist jedoch eine Orientierung, bei der die Kontaktfläche unten und das Mittel zum Bereitstellen des Elektrolyten oben angeordnet sind.

In einer weiteren bevorzugten Ausführungsform findet das Verfahren zumindest teilweise unter Erwärmung statt.

Dabei werden bevorzugt die in der folgenden Tabelle für die verschiedenen Materialien der Nanodrähte angegebenen bevorzugten beziehungsweise besonders bevorzugten Temperaturen verwendet.

| Material der | Bevorzugte | besonders bevorzugte |
|---|---|---|
| Nanodrähte | Temperatur | Temperatur |
| Kupfer | 13°...43° | 18°...28° |
| Silber | 50°...70° | 55°...65° |
| Platin | 50°...70° | 55°...65° |
| Gold | 50°...70° | 55°...65° |
| Nickel | 35°... 55° | 40°... 50° |
| Zinn | 13°...43° | 18°...28° |

Durch eine erhöhte Temperatur kann die Mobilität der Ionen im Elektrolyten erhöht werden. Damit kann das Wachstum der Nanodrähte begünstigt werden.

Die Erfindung und das technische Umfeld werden nachfolgend anhand der Figuren näher erläutert. Die Figuren zeigen besonders bevorzugte Ausführungsbeispiele, auf die die Erfindung jedoch nicht begrenzt ist. Insbesondere ist daraufhinzuweisen, dass die Figuren und insbesondere die dargestellten Größenverhältnisse nur schematisch sind. Es zeigen schematisch:
- Fig. 1:: eine Querschnittsansicht einer Anordnung wie hier beschrieben, die aber nicht unter den Schutzumfang der Ansprüche fällt, und
- Fig. 2:: eine Schnittansicht von oben durch die Strukturierungsschicht der Anordnung aus Fig. 1,
- Fig. 3a bis 3i:: neun schematische Darstellungen eines Verfahrens zum Bereitstellen einer Vielzahl von Nanodrähten,
- Fig. 4:: ein erstes Ausführungsbeispiel einer Vorrichtung zum Bereitstellen einer Vielzahl von Nanodrähten auf einer Oberfläche eines Substrats,
- Fig. 5:: ein zweites Ausführungsbeispiel einer Vorrichtung zum Bereitstellen einer Vielzahl von Nanodrähten auf einer Oberfläche eines Substrats, und
- Fig. 6:: eine Anordnung von Halbleiterchips.

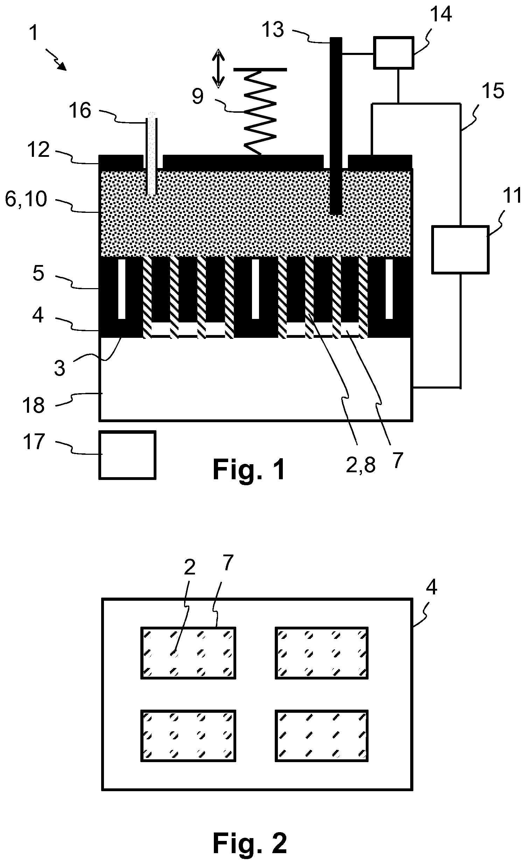

Fig. 1 zeigt eine Anordnung 1 zum Bereitstellen einer Vielzahl von Nanodrähten 2 , die aber nicht beansprucht wird.

Die Anordnung 1 umfasst einen Körper 18 mit einer Oberfläche 3, auf die die Nanodrähte 2 gewachsen werden sollen. Auf die Oberfläche 3 ist eine Strukturierungsschicht 4 aufgelegt, wobei die Strukturierungsschicht 4 mehrere Auslassungen 7 aufweist (in dieser Darstellung sind zwei Auslassungen 7 zu erkennen). An den Stellen der Auslassungen 7 sollen die Nanodrähte 2 auf die Oberfläche 3 gewachsen werden. Weiterhin ist eine auf die Strukturierungsschicht 4 aufgelegte Folie 5 vorgesehen. Die Folie 5 weist eine Vielzahl von durchgehenden Poren 8 auf, in denen die Nanodrähte 2 gewachsen werden können. Nanodrähte 2 wachsen lediglich in den Poren 8 an den Stellen der Auslassungen 7 der Strukturierungsschicht 4. An den anderen Stellen ist ein galvanisches Wachsen der Nanodrähte 2 unterbunden. Auf die Folie 5 ist ein Schwamm 10 als ein Mittel zum Bereitstellen eines Elektrolyten 6 aufgelegt. Weiterhin ist eine Elektrode 12 vorgesehen, die an dem Schwamm 10 anliegt. Zwischen der Elektrode 12 und der Oberfläche 3, die elektrisch leitend ist, kann mittels einer Spannungsquelle 11 und über Kabel 15 eine Spannung angelegt werden. Mit dieser Spannung kann das galvanische Wachsen der Vielzahl von Nanodrähten 2 realisiert werden. Weiterhin ist eine Referenzelektrode 13 vorgesehen. Zwischen der Referenzelektrode 13 und der Elektrode 12 kann mit einem Messgerät 14 eine elektrochemische Potentialdifferenz gemessen werden. Über ein Rohr 16 kann der Elektrolyt dem Schwamm 10 zugeführt werden. Der Schwamm 10 kann mittels einer als Feder ausgeführten Anpresseinheit 9 an die Folie 5 gepresst werden. Dabei ist die Anpresseinheit 9 derart befestigt, dass eine auf den Schwamm 10 einwirkende Kraft einstellbar ist. Dies ist durch den Doppelpfeil angedeutet. Weiterhin eingezeichnet ist eine Heizung 17, mittels derer das Wachstum der Nanodrähte 2 (vollständig oder nur zeitweise) unter Erwärmung stattfinden kann und/oder mittels derer die Folie 5 (zumindest teilweise) aufgelöst werden kann.

Fig. 2 zeigt die Strukturierungsschicht 4 aus Fig. 1 als eine Schnittansicht von oben. Zu erkennen sind hier die Auslassungen 7 mit den Nanodrähten 2, die nur an den Stellen der Auslassungen 7 wachsen können. Die Nanodrähte 2 haben einen kreisförmigen Querschnitt.

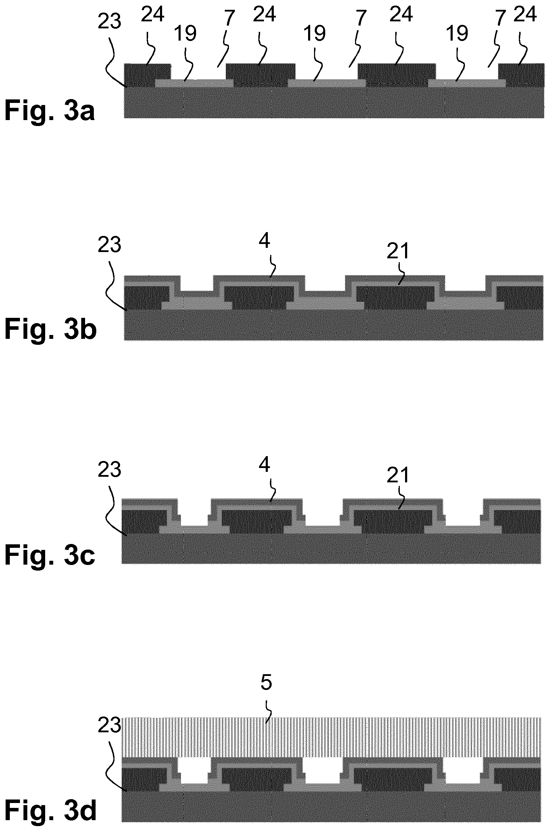

Die Fig. 3a bis 3i zeigen neun schematische Darstellungen eines Verfahrens zum Bereitstellen einer Vielzahl von Nanodrähten. In Fig. 3a ist eine Grundoberfläche 23 mit drei elektrisch leitenden Bereichen 19 gezeigt. Auf die Grundoberfläche 23 ist eine Grundstrukturierungsschicht 24 (zum Beispiel ein Lötstopplack) aufgebracht, die für jede der elektrisch leitenden Bereiche 19 jeweils eine Auslassung 7 aufweist (zum Beispiel Kontakt). Die Grundoberfläche 23 und die Grundstrukturierungsschicht 24 bilden gemeinsam eine Oberfläche 3 im Sinne der Fig. 1.

In Fig. 3b ist auf die Grundstrukturierungsschicht 24 eine elektrisch leitende Elektrodenschicht 21 und auf diese eine elektrisch isolierende Strukturierungsschicht 4 aufgebracht.

In Fig. 3c sind die Stellen der elektrisch leitenden Bereiche 19 freigelegt und alle elektrisch leitenden Bereiche 19 (die insbesondere Kontakte bilden können) miteinander verbunden, an denen Nanodrähte 2 gewachsen werden sollen.

In Fig. 3d ist eine Folie 5 auf die Strukturierungsschicht 4 aufgelegt, wobei die Folie 5 eine Vielzahl von durchgehenden Poren 8 aufweist, in denen hilfsweise gewachsene Nanodrähte 22 gewachsen werden können.

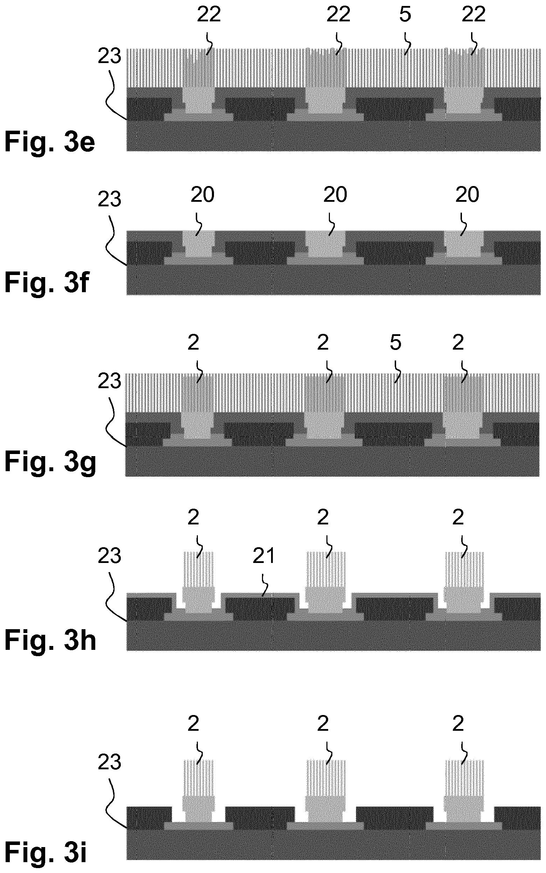

In Fig. 3e sind die hilfsweise gewachsenen Nanodrähte 22 zu erkennen, die in den Poren 8 der Folie 5 gewachsen worden sind. Die hilfsweise gewachsenen Nanodrähte 22 werden zusammen mit der Folie 5 entfernt.

In Fig. 3f ist die Situation nach Entfernen der Folie 5 mit den hilfsweise gewachsenen Nanodrähten 22 gezeigt. Es bleiben elektrisch leitende Bumps 20 übrig. Anschließend wird eine weitere Folie 5 auf die Strukturierungsschicht 4 aufgelegt und Nanodrähte 2 werden gewachsen. Die dabei erhaltenen Nanodrähte 2 sind die Nanodrähte, die nach Abschluss des Verfahrens auf den elektrisch leitenden Bereichen 19 (bzw. auf den Bumps 20) verbleiben und auf deren Wachstum das Verfahren gerichtet ist.

Fig. 3g zeigt die Nanodrähte 2 mit der Folie 5. Nach Wachstum dieser Nanodrähte 2 kann die Folie 5 entfernt werden, was zu der Darstellung von Fig. 3h führt, bei der durch einen chemischen Prozess neben der Folie 5 auch schon die Strukturierungsschicht 4 entfernt wurde. Schließlich wird die elektrisch leitende Elektrodenschicht 21 entfernt. Damit verbleiben, wie in Fig. 3i gezeigt, nur die Nanodrähte 2 und die Bumps 20 auf den elektrisch leitenden Bereichen 19 der Grundoberfläche 23.

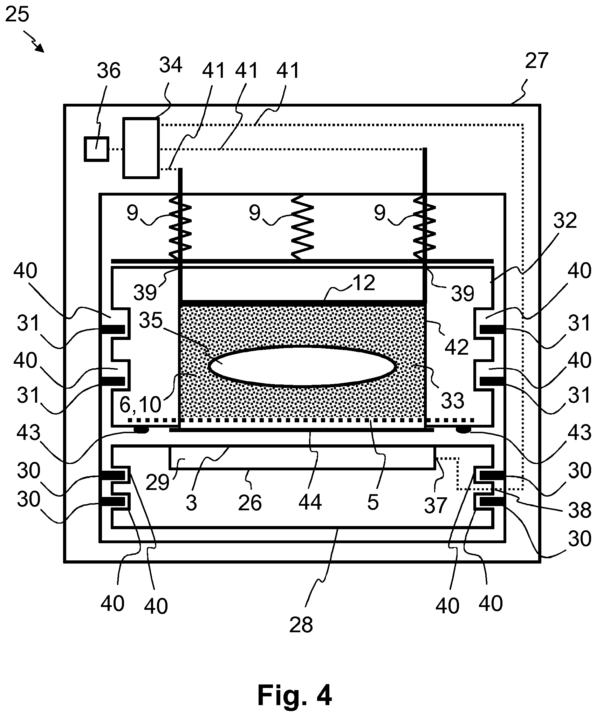

Fig. 4 zeigt ein erstes Ausführungsbeispiel einer Vorrichtung 25 zum Bereitstellen einer Vielzahl von Nanodrähten auf einer Oberfläche 3 eines Substrats 26. Die Vorrichtung 25 umfasst ein Gehäuse 27. In das Gehäuse 27 ist ein Substratmodul 28 mit einer Aufnahme 29 für das Substrat 26 über eine erste Einschubeinheit 30 eingeschoben. Weiterhin ist ein Galvanikmodul 32 mit einer Aufnahme 33 für ein Mittel zum Bereitstellen eines Elektrolyten 6 über eine zweite Einschubeinheit 31 in das Gehäuse 27 eingeschoben. Das Mittel zum Bereitstellen des Elektrolyten 6 ist als ein Schwamm 10 ausgeführt, lösbar mit der Aufnahme 33 verbunden und auswechselbar. Die erste Einschubeinheit 30 und die zweite Einschubeinheit 31 umfassen jeweils vier Schienen, die in Ausnehmungen 40 des Substratmoduls 28 beziehungsweise des Galvanikmoduls 32 eingreifen. Die Ausnehmungen 40 sind derart bemessen, dass das Galvanikmodul 32 und das Substratmodul 28 relativ zueinander in einer vertikalen Richtung (in dieser Darstellung also nach oben/unten) verschieblich ausgebildet sind. Weiterhin ist eine Anpresseinrichtung 9 umfassend drei Federn vorgesehen, mittels derer das Mittel zum Bereitstellen des Elektrolyten 6 und das Substrat 26 gegeneinander gepresst werden können.

Die Anpresseinrichtung 9 ist signaltechnisch mit einer Steuerung 34 verbunden, derart, dass eine Anpresskraft und ein zeitlicher Verlauf der Anpresskraft des Mittels zum Bereitstellen des Elektrolyten 6 an die Oberfläche 3 des Substrats 26 gesteuert werden können. Die signaltechnische Verbindung ist der Übersichtlichkeit halber nicht gezeigt.

Weiterhin ist eine Folie 5 auf dem Substrat 26 vorgesehen. Die Folie 5 weist eine Vielzahl von (hier nicht gezeigten) durchgehenden Poren auf, in denen die Nanodrähte gewachsen werden können. Die Folie 5 ist an der dem Substrat 26 zugewandten Fläche des Galvanikmoduls 32 vorgesehen. Wird die Folie 5 an die Oberfläche 3 des Substrats 26 angelegt und insbesondere daran angepresst, so können die Nanodrähte in der Folie 5 gewachsen werden.

Der Elektrolyt ist ein einem Behälter 35 bereitgestellt. Der Behälter 35 ist in dem Mittel zum Bereitstellen des Elektrolyten 6 integriert und derart ausgeführt, dass der Behälter 35 den Elektrolyten unter Druckeinwirkung (insbesondere über die Anpressvorrichtung 9) freigibt und dem Mittel zum Bereitstellen des Elektrolyten 6 zuleitet. Damit der Elektrolyt vor Gebrauch nicht aus dem Mittel zum Bereitstellen des Elektrolyten 6 austritt, ist eine Schutzfolie 44 an der Folie 5 angelegt. Die Schutzfolie 44 wird vor dem Wachstum der Nanodrähte entfernt. Damit der Elektrolyt nicht seitlich zwischen dem Substratmodul 28 und dem Galvanikmodul 32 austritt, ist eine Dichtung 43 vorgesehen.

Das Mittel zum Bereitstellen des Elektrolyten 6 und der Behälter 35 bilden eine Baueinheit und können gemeinsam in die Aufnahme 33 des Galvanikmoduls 32 eingesetzt werden. Dazu ist eine Galvanikkapsel 42 vorgesehen, die den Behälter 35 mit dem Elektrolyten, die Folie 5 und das Mittel zum Bereitstellen des Elektrolyten 6 umfasst.

Mit der Vorrichtung 25 können Nanodrähte auf der Oberfläche 3 des Substrats 26 gewachsen werden. Dazu weist die Vorrichtung 25 eine Elektrode 12 auf, die über einen Elektrodenkontakt 39 und eine Leitung 41 mit der Steuerung 34 verbunden ist. Die Elektrode 12 dient als eine für das galvanische Wachstum der Nanodrähte benötigte Elektrode. Als weitere Elektrode für das galvanische Wachstum der Nanodrähte wird die Oberfläche 3 des Substrats 26 verwendet (die gegebenenfalls erst aufgrund einer Metallisierung elektrisch leitend ist). Dazu kann das Substrat 26 beziehungsweise dessen Oberfläche 3 über einen Substratkontakt 37, eine Leitung 41, einen Substratmodulkontakt 38 und eine weitere Leitung 41 mit der Steuerung 34 verbunden werden. Über die Steuerung 34 kann das galvanische Wachstum der Nanodrähte durchgeführt werden. Dazu ist die Steuerung an eine Bedieneinheit 36 angebunden.

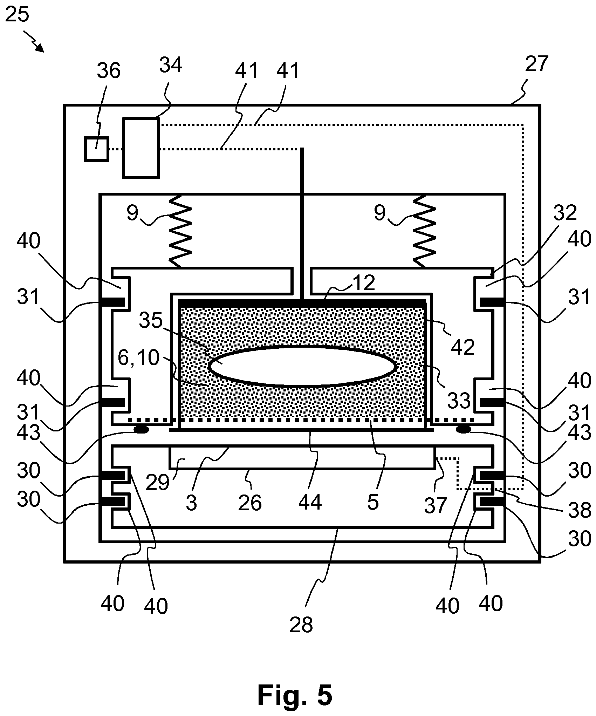

Fig. 5 zeigt ein zweites Ausführungsbeispiel einer Vorrichtung 25 zum Bereitstellen einer Vielzahl von Nanodrähten auf einer Oberfläche 3 eines Substrats 26. Das zweite Ausführungsbeispiel ist dem ersten Ausführungsbeispiel ähnlich, so dass hier nur auf die Unterschiede eingegangen wird. Das Mittel zum Bereitstellen des Elektrolyten 6 und das Substrat 26 können hier dadurch gegeneinander gepresst werden, dass eine Anpresseinrichtung 9 mit zwei Federn das Galvanikmodul 32 nach unten drückt. Die Elektrode 12 ist hier unmittelbar (und nicht über einen Elektrodenkontakt 39) über eine Leitung 41 mit der Steuerung 36 verbunden.

Bei der Kontaktfläche 18 handelt es sich vorzugsweise um eine Fläche eines Halbleiterchips, auf die die Nanodrähte gewachsen werden sollen. Auf die Kontaktfläche ist eine Strukturierungsschicht aufgelegt, wobei die Strukturierungsschicht mehrere Auslassungen aufweist. An den Stellen der Auslassungen sollen die Nanodrähte auf die Kontaktfläche gewachsen werden. Weiterhin ist eine auf die Strukturierungsschicht aufgelegte Folie vorgesehen. Die Folie weist eine Vielzahl von durchgehenden Poren auf, in denen die Nanodrähte gewachsen werden können. Nanodrähte wachsen lediglich in den Poren an den Stellen der Auslassungen der Strukturierungsschicht. An den anderen Stellen ist ein galvanisches Wachsen der Nanodrähte unterbunden. Auf die Folie ist ein Schwamm als ein Mittel zum Bereitstellen eines Elektrolyten aufgelegt. Weiterhin ist eine Elektrode vorgesehen, die an dem Schwamm anliegt. Zwischen der Elektrode und der Kontaktfläche, die elektrisch leitend ist, kann mittels einer Spannungsquelle und über Kabel eine Spannung angelegt werden. Mit dieser Spannung kann das galvanische Wachsen der Vielzahl von Nanodrähten realisiert werden. Es ist eine Referenzelektrode vorgesehen. Zwischen der Referenzelektrode und der Elektrode kann mit einem Messgerät eine elektrische Potentialdifferenz gemessen werden. Über ein Elektrolytrohr kann der Elektrolyt dem Schwamm zugeführt werden. Der Schwamm kann mittels einer Feder an die Folie gepresst werden. Dabei ist die Feder derart befestigt, dass eine auf den Schwamm einwirkende Kraft einstellbar ist. Dies ist durch den Doppelpfeil angedeutet. Weiterhin eingezeichnet ist eine Heizung, mittels derer das Wachstum der Nanodrähte (vollständig oder nur zeitweise) unter Erwärmung stattfinden kann und/oder mittels derer die Folie (zumindest teilweise) aufgelöst werden kann.

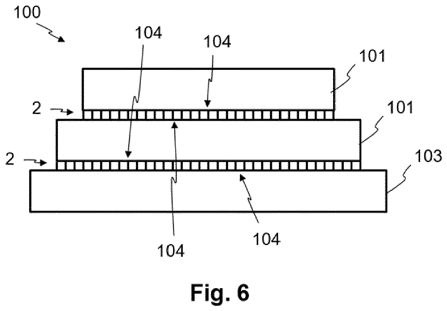

Fig. 6 zeigt eine Anordnung 100 von Halbleiterchips 101, aufweisend wenigstens zwei aufeinander aufliegende Halbleiterchips 101, die über eine Vielzahl von Nanodrähten 2 miteinander verbunden sind. Die Nanodrähte 2 sind zwischen jeweiligen Kontaktflächen der Halbleiterchips 101 ausgebildet. Die beiden in diesem Beispiel vorhandenen Halbleiterchips 101 sind auf ein Substrat 102 aufgelegt. Auch das Substrat 102 weist eine Kontaktfläche 103 auf. Der unterer der beiden Halbleiterchips 101 ist über eine Vielzahl von Nanodrähten 2 mit dem Substrat 102 verbunden.

### Bezugszeichenliste

- 1: Anordnung
- 2: Nanodraht
- 3: Oberfläche
- 4: Strukturierungsschicht
- 5: Folie
- 6: Mittel zum Bereitstellen eines Elektrolyten
- 7: Auslassung
- 8: Pore
- 9: Anpresseinheit
- 10: Schwamm
- 11: Spannungsquelle / Stromquelle
- 12: Elektrode (Gegenelektrode)
- 13: Referenzelektrode
- 14: Messgerät
- 15: Kabel
- 16: Rohr
- 17: Heizung
- 18: Körper
- 19: elektrisch leitender Bereich
- 20: elektrisch leitender Bump
- 21: elektrisch leitende Elektrodenschicht
- 22: hilfsweise gewachsene Nanodrähte
- 23: Grundoberfläche
- 24: Grundstrukturierungsschicht
- 25: Vorrichtung
- 26: Substrat
- 27: Gehäuse
- 28: Substratmodul
- 29: Aufnahme
- 30: erste Einschubeeinheit
- 31: zweite Einschubeinheit
- 32: Galvanikmodul
- 33: Aufnahme
- 34: Steuerung
- 35: Behälter
- 36: Bedieneinheit
- 37: Substratkontakt
- 38: Substratmodulkontakt
- 39: Elektrodenkontakt
- 40: Ausnehmung
- 41: Leitung
- 42: Galvanikkapsel
- 43: Dichtung
- 44: Schutzfolie

- 100: Anordnung von Halbleiterchips
- 101: Halbleiterchip
- 102: Substrat
- 103: Kontaktfläche

## Patentansprüche

1. Vorrichtung (25) zum Bereitstellen einer Vielzahl von Nanodrähten (2) auf einer Oberfläche (3) eines Substrats (26) umfassend zumindest:
- ein Gehäuse (27), wobei das Gehäuse eine erste Einschubeinheit (30) und eine zweite Einschubeinheit (31) umfasst,
- ein Substratmodul (28) mit einer Aufnahme (29) für das Substrat (26), wobei das Substratmodul (28) über die erste Einschubeinheit (30) in das Gehäuse (27) einschiebbar ist,
- ein Galvanikmodul (32) mit einer Aufnahme (33) für ein Mittel zum Bereitstellen eines Elektrolyten (6), wobei das Galvanikmodul (32) über die zweite Einschubeinheit (31) in das Gehäuse (27) einschiebbar ist.

2. Vorrichtung (25) nach Anspruch 1, wobei das Galvanikmodul (32) und/oder das Substratmodul (28) relativ zueinander in einer vertikalen Richtung verschieblich ausgebildet sind.

3. Vorrichtung (25) nach einem der vorstehenden Ansprüche, wobei die Aufnahme (33) für das Mittel zum Bereitstellen des Elektrolyten (6) relativ zum Galvanikmodul (32) in einer vertikalen Richtung verschieblich ist.

4. Vorrichtung (25) nach einem der vorstehenden Ansprüche, wobei mindestens eine Anpresseinrichtung (9) vorgesehen ist, mittels derer das Mittel zum Bereitstellen des Elektrolyten (6) und das Substrat (26) gegeneinander gepresst werden können.

5. Vorrichtung (25) nach Anspruch 4, wobei die Anpresseinrichtung (9) signaltechnisch mit einer Steuerung (34) verbunden ist, derart, dass eine Anpresskraft und/oder ein zeitlicher Verlauf der Anpresskraft gesteuert werden können.

6. Vorrichtung (25) nach einem der vorstehenden Ansprüche, wobei das Mittel zum Bereitstellen des Elektrolyten (6) lösbar mit der Aufnahme (33) verbunden ist.

7. Vorrichtung (25) nach Anspruch 6, wobei das Mittel zum Bereitstellen des Elektrolyten (6) auswechselbar ist.

8. Vorrichtung (25) nach einem der vorstehenden Ansprüche, wobei eine Folie (5) mit einer Vielzahl von durchgehenden Poren (8), in denen die Nanodrähte (2) gewachsen werden können, auf dem Substrat (26) vorgesehen ist.

9. Vorrichtung (25) nach Anspruch 26, wobei ein Magazin für die Folie (5) vorgesehen ist oder wobei die Folie (5) an der dem Substrat (20) zugewandten Fläche des Galvanikmoduls (26) vorgesehen ist.

10. Vorrichtung (25) nach einem der vorstehenden Ansprüche, wobei der Elektrolyt in einem Behälter (35) mit einem porenartig ausgebildeten Boden bereitgestellt wird.

11. Vorrichtung (25) nach Anspruch 10, wobei das Mittel zum Bereitstellen des Elektrolyten (6) und der Behälter (35) eine Baueinheit bilden.

12. Vorrichtung (25) nach einem der Ansprüche 10 oder 11, wobei eine Einrichtung vorgesehen ist, mittels derer der Behälter (35) mit Druck beaufschlagbar ist.

13. Verfahren zum Bereitstellen einer Vielzahl von Nanodrähten (2) auf einer Oberfläche (3) eines Substrats (26) mittels einer Vorrichtung (25) gemäß einem der vorstehenden Ansprüche, wobei das Verfahren zumindest die folgenden Verfahrensschritte umfasst:
a) Auflegen einer Folie (5) auf eine Oberfläche (3), wobei die Folie (5) eine Vielzahl von durchgehenden Poren (8) aufweist, in denen die Nanodrähte (2) gewachsen werden können,
b) Auflegen eines Mittels zum Bereitstellen eines Elektrolyten (6) auf die Folie (5), und
c) galvanisches Wachsen der Vielzahl von Nanodrähten (2) aus dem Elektrolyten.

## Claims

1. Device (25) for providing a multiplicity of nanowires (2) on a surface (3) of a substrate (26), comprising at least:
- a housing (27), wherein the housing comprises a first slide-in unit (30) and a second slide-in unit (31),
- a substrate module (28) with a receptacle (29) for the substrate (26), wherein the substrate module (28) can be slid by means of the first slide-in unit (30) into the housing (27),
- a galvanic module (32) with a receptacle (33) for a means for providing an electrolyte (6), wherein the galvanic module (32) can be slid by means of the second slide-in unit (31) into the housing (27).

2. Device (25) according to Claim 1, wherein the galvanic module (32) and/or the substrate module (28) are formed so as to be displaceable relative to one another in a vertical direction.

3. Device (25) according to either of the preceding claims, wherein the receptacle (33) for the means for providing the electrolyte (6) is displaceable relative to the galvanic module (32) in a vertical direction.

4. Device (25) according to one of the preceding claims, wherein at least one pressing device (9) is provided, by means of which the means for providing the electrolyte (6) and the substrate (26) can be pressed against one another.

5. Device (25) according to Claim 4, wherein the pressing device (9) is connected in terms of signal transmission to a controller (34) such that a pressing force and/or a profile with respect to time of the pressing force can be controlled.

6. Device (25) according to one of the preceding claims, wherein the means for providing the electrolyte (6) is detachably connected to the receptacle (33).

7. Device (25) according to Claim 6, wherein the means for providing the electrolyte (6) is exchangeable.

8. Device (25) according to one of the preceding claims, wherein a film (5) with a multiplicity of through-extending pores (8) in which the nanowires (2) can be grown is provided on the substrate (26).

9. Device (25) according to Claim 26, wherein a magazine for the film (5) is provided or wherein the film (5) is provided on that surface of the galvanic module (26) which faces towards the substrate (20).

10. Device (25) according to one of the preceding claims, wherein the electrolyte is provided in a container (35) with a base of porous form.

11. Device (25) according to Claim 10, wherein the means for providing the electrolyte (6) and the container (35) form a structural unit.

12. Device (25) according to either of Claims 10 and 11, wherein an apparatus is provided, by means of which the container (35) can be pressurized.

13. Method for providing a multiplicity of nanowires (2) on a surface (3) of a substrate (26) by means of a device (25) according to one of the preceding claims, wherein the method comprises at least the following method steps:
a) laying a film (5) onto a surface (3), wherein the film (5) has a multiplicity of through-extending pores (8) in which the nanowires (2) can be grown,
b) laying a means for providing an electrolyte (6) onto the film (5), and
c) galvanically growing the multiplicity of nanowires (2) from the electrolyte.

## Revendications

1. Dispositif (25) permettant de fournir une pluralité de nanofils (2) sur une surface (3) d'un substrat (26), comprenant au moins :
- un boîtier (27), le boîtier comprenant une première unité d'insertion (30) et une deuxième unité d'insertion (31),
- un module de substrat (28) pourvu d'un logement (29) pour le substrat (26), le module de substrat (28) pouvant être inséré dans le boîtier (27) par l'intermédiaire de la première unité d'insertion (30),
- un module de galvanisation (32) pourvu d'un logement (33) pour un moyen de fourniture d'un électrolyte (6), le module de galvanisation (32) pouvant être inséré dans le boîtier (27) par l'intermédiaire de la deuxième unité d'insertion (31).

2. Dispositif (25) selon la revendication 1, dans lequel le module de galvanisation (32) et/ou le module de substrat (28) sont réalisés de manière mobile l'un par rapport à l'autre dans une direction verticale.

3. Dispositif (25) selon l'une quelconque des revendications précédentes, dans lequel le logement (33) pour le moyen de fourniture de l'électrolyte (6) est mobile par rapport au module de galvanisation (32) dans une direction verticale.

4. Dispositif (25) selon l'une quelconque des revendications précédentes, dans lequel au moins un équipement de pression (9) est prévu qui permet de presser le moyen de fourniture de l'électrolyte (6) et le substrat (26) l'un contre l'autre.

5. Dispositif (25) selon la revendication 4, dans lequel l'équipement de pression (9) est relié par une technique de signalisation à une commande (34) de telle sorte qu'il est possible de commander une force de pression et/ou une courbe de temps de la force de pression.

6. Dispositif (25) selon l'une quelconque des revendications précédentes, dans lequel le moyen de fourniture de l'électrolyte (6) est relié au logement (33) de manière amovible.

7. Dispositif (25) selon la revendication 6, dans lequel le moyen de fourniture de l'électrolyte (6) est échangeable.

8. Dispositif (25) selon l'une quelconque des revendications précédentes, dans lequel une pellicule (5) pourvue d'une pluralité de pores traversants (8), dans lesquels la croissance des nanofils (2) peut être réalisée, est prévue sur le substrat (26).

9. Dispositif (25) selon la revendication 26, dans lequel un magasin pour la pellicule (5) est prévu, ou dans lequel la pellicule (5) est prévue sur la face du module de galvanisation (26) tournée vers le substrat (20).

10. Dispositif (25) selon l'une quelconque des revendications précédentes, dans lequel l'électrolyte est fourni dans un récipient (35) pourvu d'un fond réalisé à la manière de pores.

11. Dispositif (25) selon la revendication 10, dans lequel le moyen de fourniture de l'électrolyte (6) et le récipient (35) forment une unité modulaire.

12. Dispositif (25) selon l'une quelconque des revendications 10 ou 11, dans lequel un équipement est prévu qui permet de mettre le récipient (35) en pression.

13. Procédé permettant de fournir une pluralité de nanofils (2) sur une surface (3) d'un substrat (26) au moyen d'un dispositif (25) selon l'une quelconque des revendications précédentes, le procédé comprenant au moins les étapes de procédé suivantes:
a) application d'une pellicule (5) sur une surface (3), la pellicule (5) présentant une pluralité de pores traversants (8) dans lesquels la croissance des nanofils (2) peut être réalisée,
b) application d'un moyen de fourniture d'un électrolyte (6) sur la pellicule (5), et
c) croissance galvanique de la pluralité de nanofils (2) à partir de l'électrolyte.
